(19) Europäisches Patentamt
European Patent Office
Office européen des brevets

(11) **EP 2 047 605 B1**

(12) **FASCICULE DE BREVET EUROPEEN**

(45) Date de publication et mention
de la délivrance du brevet:
**06.01.2010 Bulletin 2010/01**

(21) Numéro de dépôt: **07787874.2**

(22) Date de dépôt: **25.07.2007**

(51) Int Cl.:
*H03M 13/11* *(2006.01)*

(86) Numéro de dépôt international:
**PCT/EP2007/057644**

(87) Numéro de publication internationale:
**WO 2008/012318 (31.01.2008 Gazette 2008/05)**

(54) **Procédé de décodage à passage de messages avec un classement des noeuds selon la fiabilité de voisinage**

Message-Passing Decodierung mit einer Knotenklassifizierung gemäß der Nachbarschaftszuverlässigkeit

Message-passing decoding with a node classification according to the reliability of the vicinity

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **27.07.2006 FR 0653148**

(43) Date de publication de la demande:
**15.04.2009 Bulletin 2009/16**

(73) Titulaire: **Commissariat à l'Energie Atomique Bâtiment D "Le Ponant"
25 rue Leblanc
75015 Paris (FR)**

(72) Inventeurs:
• **SAVIN, Valentin
38000 Grenoble (FR)**
• **KTENAS, Dimitri
38600 Fontaine (FR)**

(74) Mandataire: **Ilgart, Jean-Christophe et al
Brevalex
3, rue du Docteur Lancereaux
75008 Paris (FR)**

(56) Documents cités:
**US-A1- 2005 216 821     US-A1- 2005 268 204**

• **JAEBUM KIM ET AL: "Fast convergence decoding scheme tor regular LDPC codes" PROC., IEEE INTERNAT. SYMPOSIUM ON INTELLIGENT SIGNAL PROCESSING AND COMMUNICATION SYSTEMS, ISPACS 2004, SEOUL, KOREA, 18 novembre 2004 (2004-11-18), - 19 novembre 2004 (2004-11-19) pages 454-458, XP010806182 ISBN: 0-7803-8639-6**
• **MAO Y ET AL: "A NEW SCHEDULE FOR DECODING LOW-DENSITY PARITY-CHECK CODES" PROC., IEEE GLOBAL TELECOMMUNICATIONS CONFERENCE, GLOBECOM 2001, SAN ANTONIO, TX, vol. 2 OF 6, 25 novembre 2001 (2001-11-25), - 29 novembre 2001 (2001-11-29) pages 1007-1010, XP001099256 ISBN: 0-7803-7206-9**
• **MACKAY D J C: "Good error-correcting codes based on very sparse matrices" IEEE TRANSACTIONS ON INFORMATION THEORY, IEEE SERVICE CENTER, PISCATAWAY, NJ, US, vol. 45, no. 2, mars 1999 (1999-03), pages 399-431, XP002143042 ISSN: 0018-9448**
• **RYAN E W: "An introduction to LDPC codes" INTERNET CITATION, [Online] 19 août 2003 (2003-08-19), XP002336953 Extrait de l'Internet: URL:http://www.cseee.www.edu/wcrl/ldpc.htm l> [extrait le 2004-02-25]**

**Description**

**DOMAINE TECHNIQUE**

La présente invention concerne le décodage de codes correcteurs d'erreurs dans le domaine des télécommunications ou de l'enregistrement de données. Plus précisément, l'invention est relative à une méthode de décodage itératif à passage de messages de codes correcteurs d'erreurs susceptibles d'une représentation par graphe bipartite, tels que les codes LDPC *(Low Density Parity Check)* ou les turbocodes.

**ÉTAT DE LA TECHNIQUE ANTÉRIEURE**

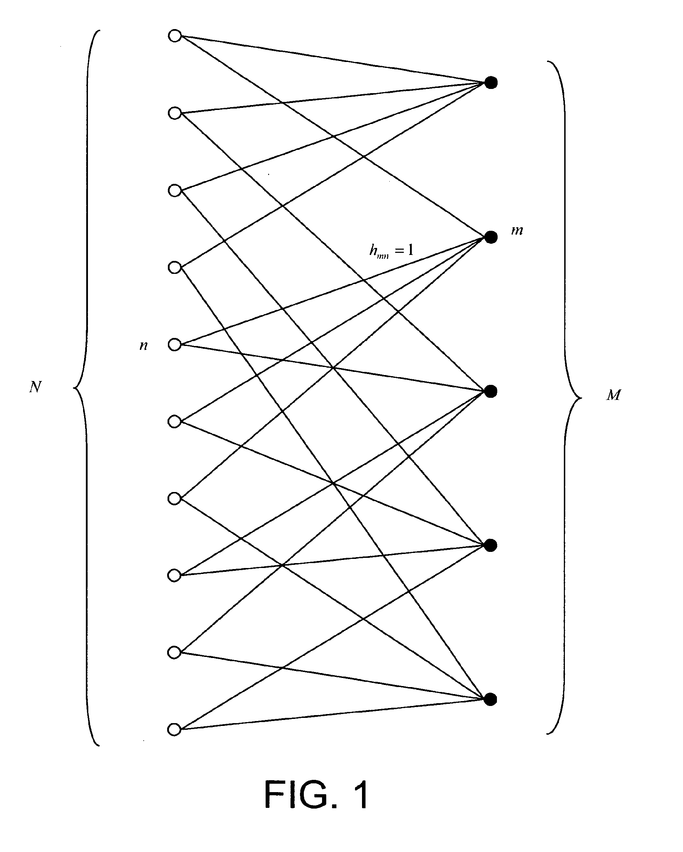

Les codes correcteurs d'erreurs susceptibles de représentation par graphe bipartite recouvrent une large variété de codes, notamment les codes LDPC, initialement décrits par R. Gallager dans son article intitulé « Low density parity check codes » publié dans IEEE Trans. Inform. Theory, vol. IT-8, pages 21-28, 1962, dont les intéressantes propriétés ont été redécouvertes récemment, et les turbocodes introduits par C. Berrou et al. dans son article fondateur « Near optimum error correcting coding and decoding : turbocodes » paru dans IEEE Trans. Inform. Theory, vol. 44, N˚ 10, pages 1261-1271, 1996.
On appelle graphe bipartite un graphe non orienté dont l'ensemble des noeuds est constitué de deux sous-ensembles disjoints tels que deux noeuds quelconques d'un même sous-ensemble ne sont pas reliés entre eux par une arête du graphe.
Certains codes correcteurs d'erreurs sont susceptibles d'une représentation par graphe bipartite. Le graphe est partitionné en un premier sous-ensemble de noeuds associés aux symboles constituant un mot de code et un second sous-ensemble de noeuds associés aux contraintes du code, typiquement aux contrôles de parité. Un graphe bipartite associé à un groupe de contraintes est encore appelé graphe de Tanner.
Les symboles du mot de code sont en général des éléments du corps de Galois $F_2 = \{0,1\}$ , autrement dit des bits, mais ils peuvent plus généralement être des éléments d'un corps de caractéristique 2 quelconque $F_{2p}$ et par conséquent d'un alphabet $2^p$-aire. Dans la suite, nous nous limiterons sans perte de généralité au cas $p = 1$, c'est-à-dire aux codes binaires.
Les codes susceptibles de représentation par graphe bipartite peuvent être décodés au moyen d'un décodage itératif à passage de messages, dit aussi de type MP *(Message Passing)* ou BP *(Belief Propagation).* On trouvera une description générique de cette méthode de décodage dans la thèse de N. Wiberg intitulée « Codes and decoding on général graphs », 1996. Le décodage itératif de type MP est en fait une généralisation d'algorithmes bien connus dans le domaine du décodage à savoir l'algorithme « forward-backward » utilisé pour les turbocodes et l'algorithme de Gallager pour les codes LDPC.
Dans un souci de simplification, nous rappellerons ci-après le principe du décodage itératif par passage de messages dans le cadre d'un code LDPC. Nous considérons un code linéaire *(K,N)* où *K* est la dimension du code représentant le nombre de bits d'information et *N* est la longueur du code, représentant le nombre de bits codés. *M =
N - K* correspond au nombre de bits de parité ou, de manière équivalente, le nombre de contraintes de parité.
On a illustré en Fig. 1 le graphe de Tanner d'un code linéaire *(K,N).* On a fait figurer à gauche du graphe les noeuds correspondant aux bits du code, encore dénommés noeuds de type « variable » ou encore plus simplement « variables » et à droite les noeuds correspondant aux contrôles de parité, encore dénommés noeuds de type « contrôle » ou encore plus simplement « contrôles ». La matrice d'incidence du graphe correspond à la matrice de parité du code qui est de dimension $M \times N.$ Ainsi, le graphe bipartite comprend *N* noeuds de type « variable » et *M* noeuds de type « contrôle », un noeud *n* de variable étant relié à un noeud *m* de contrôle si et seulement si $h_{mm} = 1$. Par exemple, le graphe de la Fig. 1, correspond à un code (10,5) possédant la matrice de parité suivante:

$$\mathbf{H} = \begin{pmatrix} 1 & 1 & 1 & 1 & 0 & 0 & 0 & 0 & 0 & 0 \\ 1 & 0 & 0 & 0 & 1 & 1 & 1 & 0 & 0 & 0 \\ 0 & 1 & 0 & 0 & 1 & 0 & 0 & 1 & 1 & 0 \\ 0 & 0 & 1 & 0 & 0 & 1 & 0 & 1 & 0 & 1 \\ 0 & 0 & 0 & 1 & 0 & 0 & 1 & 0 & 1 & 1 \end{pmatrix} \qquad (1)$$

On rappelle de manière générale qu'un code linéaire est défini par une matrice génératrice **G** dont les éléments sont des valeurs binaires et qu'un mot de code $\mathbf{X} = (X_1, X_2, .., X_N)$ est obtenu à partir d'un mot de bits d'information $\mathbf{a} = (a_1, a_2, .., a_k)$ au moyen de :

$$\mathbf{x} = \mathbf{aG} \qquad (2)$$

Puisque tous les mots de code vérifient les contrôles de parité, on a la relation :

$$\mathbf{H}.\mathbf{G}^{\mathbf{T}} = 0 \qquad (3)$$

où l'on a noté $G^T$ la transposée de la matrice $\mathbf{G}$ .

Le mot de code $\mathbf{x}$ est transmis sur un canal de communication ou enregistré sur un support de données. A la réception ou à la lecture du support, on récupère un version bruitée de $\mathbf{x}$, soit $\mathbf{y} = (y_1, y_2, ..., y_N)$. L'opération de décodage consiste à retrouver $\mathbf{x}$ et donc $\mathbf{a}$ à partir de l'observation $\mathbf{y}$.

Nous conviendrons des notations suivantes avant de décrire le principe du décodage itératif à passage de messages:

H(n) désigne l'ensemble des contrôles reliés à la variable $n$ dans le graphe bipartite, autrement dit l'ensemble des noeuds adjacents au noeud $n$;

$H(m)$ est l'ensemble des variables reliées au contrôle $m$ dans le graphe bipartite, autrement dit l'ensemble des noeuds adjacents au noeud $m$ ;

$\alpha_n$ représente l'information a *priori* concernant la variable $n$ du graphe bipartite, autrement dit l'information a *priori* concernant le $n^{\text{ième}}$ bit du mot de code. Cette information prend en compte le signal reçu et les caractéristiques du canal de transmission. Elle constitue l'entrée du décodeur et est généralement fournie par le démodulateur sous la forme de valeurs souples, soit en termes de probabilités:

$$\alpha_n = (p_n^0, p_n^1) \qquad (4)$$

où $p_n^a = \Pr(x_n = a \,|\, y_n)$ , , $a \in \{0,1\}$,

soit, plus commodément sous la forme d'un rapport logarithmique de probabilités ou LLR :

$$\alpha_n = \ln\left(\frac{\Pr(x_n = 0 \,|\, y_n)}{\Pr(x_n = 1 \,|\, y_n)}\right) \qquad (5)$$

Ainsi, pour un bruit BBCG (bruit blanc centré gaussien) et une modulation BPSK, le démodulateur calcule simplement :

$$\alpha_n = \frac{2}{\sigma^2} y_n \qquad (6)$$

où $\sigma^2$ est la variance du bruit.

$\alpha_{mm}$ représente le message transmis par la variable *n* au contrôle *m* ∈ *H(n)*. Par référence aux turbocodes, $\alpha_{mm}$ est encore appelée information extrinsèque ;

$\beta_{mm}$ représente de manière symétrique le message transmis par le contrôles *m* à la variable *n* ∈ *H(m)*. Il est également qualifié d'information extrinsèque ;

$\hat{\alpha}_n$ représente l'information a *posteriori* relative à la variable *n* : elle prend en compte à la fois l'information a *priori* $\alpha_n$ et les messages $\beta_{mm}$ reçus par la variable *n* de ses contrôles adjacents pendant le décodage ;

$\overline{\alpha}_n$ est la valeur dure correspondant à la valeur souple $\hat{\alpha}_n$, autrement dit la décision prise pour le bit $x_n$.

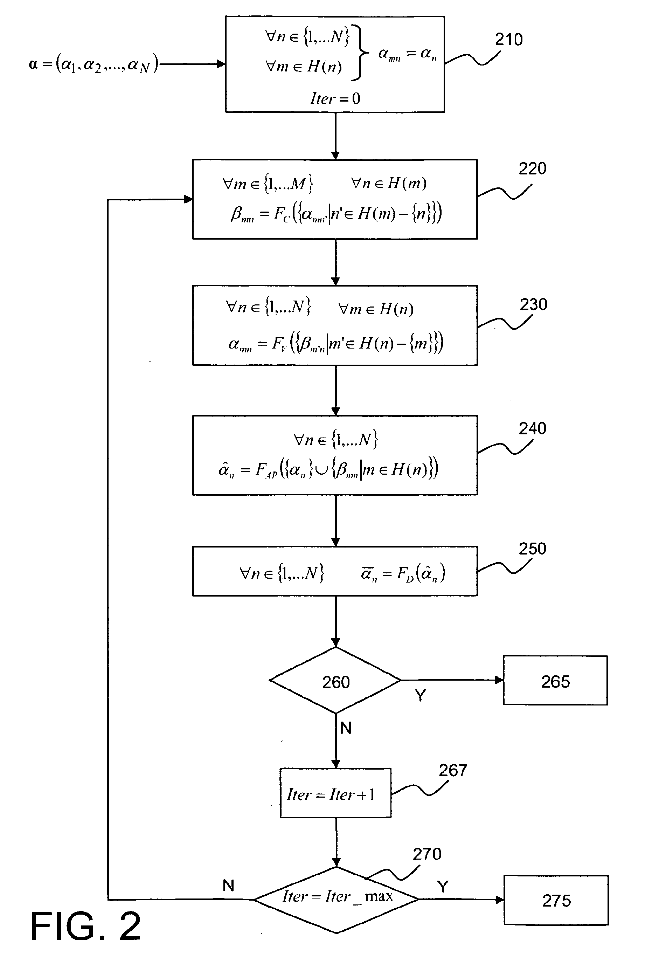

Le principe du décodage itératif par passage de messages est illustré en Fig. 2.

A l'étape 210, on procède à l'initialisation des messages $\alpha_{mm}$, pour chaque couple de variable *n* et de contrôle *m* ∈ *H(n)*. Les messages $\alpha_{mm}$ sont généralement initialisés par les informations a *priori* c'est-à-dire : $\alpha_{mm} = \alpha_n, \forall m \in H(n)$. On initialise également le compteur d'itérations *Iter* à 0.

L'étape d'initialisation est suivie d'une boucle d'itération comprenant les étapes suivantes :

En 220, on procède au traitement des contrôles. Plus précisément, pour chaque contrôle *m*, on calcule les messages $\beta_{mm}$ du contrôle *m* à destination des variables respectives *n* ∈ *H(m)*, soit :

$$\beta_{mn} = F_C\left(\left\{\alpha_{mn'}\middle| n' \in H(m) - \{n\}\right\}\right) \qquad (7)$$

où l'on a noté $F_c$ la fonction de traitement des contrôles. Pour un couple de noeuds *m, n* ∈ *H(m)* quelconque donné, le message $\beta_{mm}$ est calculé en fonction des messages qu'a lui-même reçu le contrôle *m* des variables *n'*∈ *H(m)*-{*n*}. On constate par conséquent qu'il n'y a pas renvoi d'information extrinsèque d'un noeud de variable sur lui-même. L'étape de traitement des contrôles est aussi appelée étape horizontale.

En 230, on procède symétriquement au traitement des variables. Plus précisément, pour chaque variable *n*, on calcule les messages $\alpha_{mm}$ à destination des contrôles respectifs *m* ∈ *H(n)*, soit :

$$\alpha_{mn} = F_V\left(\left\{\beta_{m'n}\middle| m' \in H(n) - \{m\}\right\}\right) \qquad (7')$$

où l'on a noté $F_v$ la fonction de traitement des variables. Pour un couple de noeuds *n, m* ∈ *H(n)* donné, le message $\alpha_{mm}$ est calculé en fonction des messages qu'a elle-même reçu la variable *n* des contrôles *m'*∈ *H(n)*-{*m*}, de sorte que, comme précédemment, il n'y a pas renvoi d'information extrinsèque d'un noeud sur lui-même. L'étape de traitement des variables est aussi appelée étape verticale.

En 240, on estime l'information a *posteriori* $\hat{\alpha}_n$ à partir de l'information a *priori* $\alpha_n$ et des messages $\beta_{mm}$ reçus par la variable *n* de la part de ses noeuds de contrôle adjacents *m* ∈ *H(n)*, ce que l'on exprime symboliquement par :

$$\hat{\alpha}_n = F_{AP}\left(\left\{\alpha_n\right\} \cup \left\{\beta_{mn}\middle| m \in H(n)\right\}\right) \qquad (8)$$

où l'on a noté $F_{AP}$ la fonction d'estimation a *posteriori*.

En 250, on prend une décision sur les valeurs dures $\overline{\alpha}_n$, à partir des valeurs souples $\hat{\alpha}_n$, soit :

$$\overline{\alpha}_n = F_D\left(\hat{\alpha}_n\right) \qquad (8')$$

où l'on a noté $F_D$ la fonction de décision. Typiquement, pour une modulation BPSK, la décision est prise sur le signe de la valeur souple, c'est-à-dire $\overline{\alpha}_n = \text{sgn}(\hat{\alpha}_n)$. On identifiera dans la suite pour raison de commodité la valeur d'un bit avec sa valeur modulée. On représentera conventionnellement le bit « 0 » par la valeur « +1 » et le bit « 1 » par la valeur « -1 ».

En 260, on vérifie si le vecteur $\overline{\alpha} = (\overline{\alpha}_1, \overline{\alpha}_2,..,\overline{\alpha}_n)$ est un mot de code, c'est-à-dire s'il satisfait aux contrôles de parité. Dans l'affirmative, on sort de la boucle en 265, le mot décodé étant $\overline{\alpha}$. Dans la négative, on incrémente le nombre d'itérations en 267 et on compare en 270, si le nombre d'itérations effectuées *Iter* a atteint une valeur de seuil *Iter_max*. Si ce n'est pas le cas, on poursuit le décodage itératif en rebouclant à l'étape 220. A défaut, on conclut à l'échec de l'opération de décodage et on sort en 275.

L'ordre des étapes dans la boucle d'itération peut différer de celui exposé en Fig. 2. En particulier, on peut intervertir l'ordre de traitement des variables et des contrôles et alors commencer par une initialisation des messages $\beta_{mm}$ : $\beta_{mm} = 0$, $\forall n \in \{1,...N\}$ et $\forall m \in H(n)$.

Selon le principe de décodage itératif présenté en Fig. 2, on procède au traitement de tous les contrôles puis de toutes les variables ou bien, comme mentionné ci-dessus, au traitement de toutes les variables puis de tous les contrôles. On parle alors d'« ordonnancement parallèle » ou encore d'« ordonnancement par inondation » (flooding scheduling). D'autres types d'ordonnancements ont été proposés dans la littérature ; ils peuvent être classés en deux catégories :

- ordonnancement de type série, catégorie dans laquelle on peut ranger les ordonnancements dénommés « serial scheduling », « shuffled-BP », « horizontal shuffled » ou « vertical shuffled ». L'ordonnancement de type série est applicable aussi bien aux contrôles qu'aux variables. Pour une application aux contrôles, le décodage utilise la stratégie suivante :

  • on procède tout d'abord au traitement d'un seul contrôle *m* en calculant les messages $\beta_{mm}$ à destination des variables $n \in H(m)$ ;
  • on met à jour et on transmet les messages $\alpha_{m'n}$ de chaque variable $n \in H(m)$ à destination des contrôles $m' \in H(n) - \{m\}$. On met également à jour les informations a *posteriori* $\hat{\alpha}_n$ relatives à ces mêmes variables;
  • on procède au traitement du contrôle suivant et l'on itère les deux étapes précédentes jusqu'à épuisement des contrôles.

De manière duale, on peut effectuer un traitement variable par variable au lieu d'effectuer un traitement contrôle par contrôle. Selon le cas envisagé, on parlera d'ordonnancement « horizontal shuffled » ou d'ordonnancement « vertical shuffled ».

On peut aussi hybrider les deux ordonnancements précités sous la forme d'un ordonnancement dit « mixte » ou « group-shuffled ». On trouvera une description de la stratégie de décodage correspondant à un ordonnancement mixte dans l'article de J. Zhang et al. intitulé « Shuffled iterative decoding » paru dans IEEE Trans. On Comm., Vol. 53, N˚ 2, Février 2005, pages 209-213. La stratégie est basée sur une partition des noeuds par groupes, le traitement étant en parallèle au sein d'un groupe et en série d'un groupe au suivant. Plus précisément, pour une partition en groupes de contrôles:

• on procède au traitement d'un premier groupe *G* formé par les contrôles $\{m_1, m_2,.., m_g\}$ en calculant les messages $\beta_{m_i n}$ à destination des variables $n \in H(m_i)$, pour $i = 1,...,g$ ;

• on met à jour et on transmet les messages $\alpha_{m'n}$ de chaque variable $n \in H(m_i)$, $i = 1,...,g$ à destination des contrôles respectifs $m' \in H(n)-\{m_i\}$. On met également à jour les informations a *posteriori* $\hat{\alpha}_n$ relatives à ces mêmes variables ;

• on procède au traitement du groupe de contrôles suivant et l'on itère les deux étapes précédentes jusqu'à épuisement des groupes de contrôles.

De manière duale, on peut opérer sur la base d'une partition par groupes de variables au lieu d'une partition par groupes de contrôles.

On a illustré schématiquement dans les Figs. 3, 4 et 5 le mécanisme de passage de messages respectivement pour un ordonnancement parallèle, un ordonnance série et un ordonnancement mixte. On a supposé que l'on procédait au traitement des contrôles avant le traitement des variables. En Fig. 3 on a fait figurer la première étape de traitement des contrôles (a) et la première étape de traitement des variables (b). En Figs. 4 et 5 on a fait figurer la première (a) et la seconde étape (c) de traitement des contrôles ainsi que la première étape (b) et la seconde étape de traitement des variables (d). En Fig. 5, l'ensemble des noeuds de contrôle a été partitionné en deux groupes notés $G_1$ et $G_2$ qui sont traités séquentiellement.

On remarquera que l'ordonnancement série et l'ordonnancement parallèle peuvent être vus en fait comme des cas particuliers d'ordonnancement mixte, le premier correspondant au cas où les groupes sont réduits à des singletons, le second correspondant au cas où un groupe comprend l'ensemble de tous les noeuds de contrôle (resp. de variable).

Le document US 2005/0268204 décrit un décodeur de codes LDPC dans lequel, sur la base des fiabilités des valeurs de probabilité des éléments binaires acquis par l'unité de détection, une unité de contrôle détermine un timing des opérations pour exécuter une opération LDPC.

On connaît deux algorithmes principaux de décodage itératif à passage de messages pour les codes LDPC : l'algorithme SPA *(Sum Product Algorithm),* encore appelé « log-BP » et l'algorithme « Min-Sum », encore appelé « based BP ». On trouvera une description détaillée de ces deux algorithmes dans l'article de W.E. Ryan intitulé « An introduction to LDPC codes », publié dans CRC Handbook for coding and signal processing for recording systems, et disponible sous le lien www.csee.wvu.edu/wcrl/ldpc.htm.

Les algorithmes SPA et Min-Sum ne diffèrent que par l'étape de traitement des contrôles qui sera détaillée plus loin. Les autres étapes sont identiques, à savoir :

L'étape 230 de traitement des variables consiste à calculer les messages $\alpha_{mm}$ comme suit :

$$\alpha_{mn} = \ln\left(\frac{\Pr(x_n = 0 | y_n, B_{mn}^*, C_{mn})}{\Pr(x_n = 1 | y_n, B_{mn}^*, C_{mn})}\right) \quad (10)$$

où $B_{mn}^*$ représente l'ensemble des messages $\beta_{m'n}$ reçus par la variable *n* de la part des contrôles $m' \in H(n)$-{m} et $C_{mn}$ représente l'évènement correspondant à un contrôle de parité vérifié pour chacun de ces contrôles. Sous réserve de l'indépendance des $y_n$, on montre que $\alpha_{mn}$ peut s'exprimer sous forme de LLR par :

$$\alpha_{mn} = \alpha_n + \sum_{m' \in H(n)-\{m\}} \beta_{m'n} \quad (11)$$

L'étape 240 d'estimation de l'information a posteriori consiste à calculer :

$$\hat{\alpha}_n = \ln\left(\frac{\Pr(x_n = 0 | y_n, B_n, C_n)}{\Pr(x_n = 1 | y_n, B_n, C_n)}\right) \quad (12)$$

où $B_n$ représente les messages reçus par la variable *n* de tous les contrôles de *H(n)* et $C_n$ représente l'évènement correspondant à un contrôle de parité vérifié pour chacun de ces contrôles. Sous la même hypothèse que précédemment, on montre que $\hat{\alpha}_n$ peut s'exprimer sous forme de LLR par :

$$\hat{\alpha}_n = \alpha_n + \sum_{m \in H(n)} \beta_{mn} \quad (13)$$

On remarque d'après (11) et (13) que :

$$\alpha_{mn} = \hat{\alpha}_n - \beta_{mn} \quad (14)$$

L'étape 230 de traitement des variables peut par conséquent être placée en fin d'itération, après l'estimation de l'information a *posteriori.* L'expression (14) traduit le fait que l'on ne retourne pas l'information extrinsèque (ici $\beta_{mn}$) envoyée par un noeud ( *m* ) vers lui-même.

L'étape 250 de décision des valeurs dures est simplement réalisée par :

$$\overline{\alpha}_n = \mathrm{sgn}(\hat{\alpha}_n) \tag{15}$$

où sgn(*x*)=1 si *x* est positif et sgn(*x*) = -1 sinon.

La vérification en 260 des contrôles de parité sur les valeurs dures passe par le calcul des contrôles de parité :

$$c_m = \prod_{n \in H(m)} \overline{\alpha}_n \;,\quad m = 1,...,M \tag{16}$$

Les contrôles de parité sont tous satisfaits si et seulement si :

$$\sum_{m=1}^{M} c_m = M \tag{17}$$

L'étape de traitement des contrôles 220 consiste à calculer, pour l'algorithme SPA :

$$\beta_{mn} = \ln\left( \frac{\mathrm{Pr}\left(c_m = 1 \middle| x_n = 0, A_{mn}^*\right)}{\mathrm{Pr}\left(c_m = 1 \middle| x_n = 1, A_{mn}^*\right)} \right) \tag{18}$$

où $c_m$ =1 signifie une condition de parité satisfaite pour le contrôle *m* et $A_{mn}^*$ représente l'ensemble des messages $\alpha_{mn'}$ reçus par le contrôle *m* de la part des variables $n' \in$ *H(m)-{n}*. On montre que $\beta_{mn}$ peut s'exprimer par :

$$\beta_{mn} = \left( \prod_{n' \in H(m)-\{n\}} \mathrm{sgn}(\alpha_{mn'}) \right) \cdot \Phi\left( \sum_{n' \in H(m)-\{n\}} \Phi(|\alpha_{mn'}|) \right) \tag{19}$$

avec $\Phi(x) = \ln\left( \dfrac{e^x + 1}{e^x - 1} \right) = -\ln\left( \tanh\left( \dfrac{x}{2} \right) \right)$

Le traitement des contrôles selon l'algorithme Min-Sum correspond à une simplification de l'expression (19). Du fait de la décroissance rapide de la fonction $\phi(x)$ et de l'égalité de $\phi(x)$ avec sa réciproque, i.e. $\phi(\phi(x)) = x$, on peut légitimement effectuer l'approximation suivante :

$$\beta_{mn} = \left( \prod_{n' \in H(m) - \{n\}} \mathrm{sgn}(\alpha_{mn'}) \right) \cdot \min_{n' \in H(m) - \{n\}} \left( |\alpha_{mn'}| \right) \qquad (20)$$

L'algorithme de décodage Min-Sum est sensiblement plus simple que l'algorithme de décodage SPA car il n'effectue que des additions, comparaisons et changements de signe. En outre, les performances de l'algorithme Min-Sum sont indépendantes de l'estimation de la variance du bruit $\sigma^2$.

Bien que les performances de l'algorithme de décodage SPA soient meilleures que celles de l'algorihme Min-Sum, elles peuvent sévèrement se dégrader dans le cas d'une mauvaise estimation de la puissance de bruit.

L'objet général de la présente invention est de proposer un algorithme de décodage itératif de type à passage de messages permettant de décoder un code correcteur d'erreurs susceptible de représentation par graphe bipartite, possédant de meilleures performances en termes de taux d'erreur et de vitesse de convergence que les algorithmes de même type connus de l'état de la technique.

Un premier objet de l'invention est de proposer un algorithme de décodage itératif de type à passage de messages permettant de décoder un code LDPC avec une complexité nettement inférieure à celle de l'algorithme SPA tout en présentant, pour un rapport signal à bruit donné, des performances comparables, voire supérieures, en termes de taux d'erreur, et, de surcroît, ne nécessitant pas une estimation de la puissance de bruit.

Un autre objet particulier de la présente invention est de proposer un algorithme de décodage de type à passage de messages permettant le décodage de codes LDPC avec une vitesse de convergence plus élevée que celle des algorithmes SPA ou Min-Sum.

## EXPOSÉ DE L'INVENTION

La présente invention est définie par une méthode de décodage itératif de type à passage de messages pour décoder un code correcteur d'erreurs susceptible de représentation par un graphe bipartite comprenant une pluralité de noeuds de variable et une pluralité de noeuds de contrôle, ladite méthode étant telle que, pour chaque itération d'une pluralité d'itérations de décodage :

- on effectue un classement des noeuds de variable ou bien des noeuds de contrôle en fonction des degrés de fiabilité respectifs des informations de décodage disponibles en des voisinages de ces noeuds, un noeud possédant un degré de fiabilité élevé étant classé avant un noeud possédant un faible degré de fiabilité ;
- les noeuds ainsi classés passent chacun au moins un message à un noeud adjacent, dans l'ordre défini par ledit classement.

Selon un premier mode de réalisation, ledit classement comprend, pour chaque noeud à classer, le calcul d'une mesure de fiabilité des informations présentes, envoyées ou reçues par les noeuds situés à moins d'une distance prédéterminée de ce dernier au sein du graphe bipartite, et le tri des valeurs des mesures ainsi obtenues.

Pour chaque itération de ladite pluralité, on opère alors séquentiellement sur les noeuds classés dans l'ordre défini par ledit classement et, pour chaque noeud classé, on calcule les messages à destination des noeuds qui lui sont adjacents et, pour chacun desdits noeuds adjacents, les messages à destination des noeuds eux-mêmes adjacents à celui-ci.

Selon un second mode de réalisation, ledit classement comprend, pour chaque noeud à classer, le calcul d'une mesure de fiabilité des informations présentes, envoyées ou reçues par les noeuds situés à moins d'une distance prédéterminée de ce noeud au sein du graphe bipartite. Les noeuds sont groupés par intervalles de valeurs de ladite mesure.

Si la mesure de fiabilité est à valeurs entières, on stocke pour chacune desdites valeurs entières, dans une zone de mémoire qui est associée à cette valeur, les indices des noeuds dont la mesure de fiabilité est égale à cette dernière.

Pour chaque itération de ladite pluralité, on opère séquentiellement sur les groupes de noeuds dans l'ordre défini par ledit classement et, pour chaque groupe de noeuds, on calcule les messages à destination des noeuds qui leur sont adjacents et, pour chacun desdits noeuds adjacents, les messages à destination des noeuds eux-mêmes adjacents à ces derniers.

Selon une variante, chaque itération de ladite pluralité comprend en outre, pour chaque noeud de variable dudit graphe bipartite, une étape de calcul d'une information a *posteriori* en fonction d'une information a *priori* déjà présente dans ce noeud et des messages reçus par ce noeud en provenance des noeuds de contrôle adjacents.

L'étape de calcul d'information a *posteriori* peut être suivie d'une étape de décision sur la valeur dure de ladite variable.

On teste alors si les valeurs dures des variables ainsi obtenues vérifient les contrôles de parité associés à tous les noeuds de contrôle du graphe et, dans l'affirmative, on fournit comme mot décodé le mot constitué desdites valeurs dures.

Avantageusement, le classement est interrompu après un nombre d'itérations de décodage prédéterminé, la méthode de décodage poursuivant ensuite ses itérations de décodage en absence dudit classement desdits noeuds de variables ou bien desdits noeuds de contrôle.

Le classement est interrompu si le minimum, en valeur absolue, des différences entre les valeurs a *posteriori* et des valeurs a *priori* desdites variables est supérieur à une valeur de seuil prédéterminé, la méthode de décodage poursuivant ensuite ses itérations de décodage en absence dudit classement desdits noeuds de variables ou bien desdits noeuds de contrôle.

Dans une première application, ledit code correcteur d'erreurs est un turbocode.

Dans une seconde application, ledit code correcteur d'erreurs est un code LDPC *(K,N)* représenté par un graphe bipartite à *N* noeuds de variable et *M = N-K* noeuds de contrôle.

Dans ce dernier cas, le message $\beta_{mn}$ d'un noeud de contrôle d'indice $m \in \{1,..,M\}$ à un noeud de variable d'indice $n \in \{1,..,N\}$ pourra être calculé par :

$$\beta_{mn} = \left( \prod_{n' \in H(m)-\{n\}} \mathrm{sgn}(\alpha_{mn'}) \right) . \Phi\left( \sum_{n' \in H(m)-\{n\}} \Phi\big(|\alpha_{mn'}|\big) \right)$$

où $\alpha_{mn'}$ désigne le message du noeud de variable d'indice *n'* au noeud de contrôle d'indice *m, H(m)* l'ensemble des noeuds de variable adjacents au noeud de contrôle d'indice *m* , sgn($x$) = 1 si $x$ est positif et sgn($x$) = -1 sinon, et

$$\Phi(x) = \ln\left( \frac{e^x + 1}{e^x - 1} \right).$$

Alternativement, le message $\beta_{mn}$ d'un noeud de contrôle d'indice $m \in \{1,..,M\}$ à un noeud de variable d'indice $n \in \{1,..,N\}$ pourra être calculé par :

$$\beta_{mn} = \left( \prod_{n' \in H(m)-\{n\}} \mathrm{sgn}(\alpha_{mn'}) \right) . \min_{n' \in H(m)-\{n\}} \big(|\alpha_{mn'}|\big)$$

où $\alpha_{mn'}$ désigne le message du noeud de variable d'indice *n'* au noeud de contrôle d'indice *m, H(m)* l'ensemble des noeuds de variable adjacents au noeud de contrôle d'indice *m*, sgn($x$)=1 si $x$ est positif et sgn($x$) = -1 sinon.

Selon un exemple de réalisation, le classement porte sur les noeuds de contrôle et ladite distance prédéterminée est égale à 2. La mesure de fiabilité d'un noeud de contrôle d'indice *m* est alors calculée par :

$$\tilde{f}_2(m) = c + \sum_{n \in H(m)} \min\big(1, Card\{m' \in H(n) - \{m\}|c_{m'} = -1\}\big)$$

où *H(m)* désigne l'ensemble des noeuds de variable adjacents au noeud de contrôle d'indice *m, H(n)* l'ensemble des noeuds de contrôle adjacents au noeud de variable d'indice *n, Card(.)* désigne le cardinal d'un ensemble, avec $c = 0$ si $c_m = +1$ et $c = \delta_{max} +1$ si $c_m = -1$ où $\delta_{max}$ est le degré maximal des noeuds de contrôle dans le graphe bipartite, et où $c_m = +1 / c_m = -1$ signifient respectivement que le contrôle de parité est vérifié/n'est pas vérifié, pour le noeud de contrôle d'indice *m*.

L'invention concerne enfin un programme d'ordinateur comprenant des moyens logiciels adaptés à mettre en oeuvre les étapes de la méthode de décodage définie plus haut lorsqu'il est exécuté par un ordinateur.

**BRÈVE DESCRIPTION DES DESSINS**

La Fig. 1 représente un exemple de graphe de Tanner pour un code *(K,N)* ;
La Fig. 2 illustre de manière schématique le principe d'un décodage itératif par passage de messages connu de l'état de la technique ;

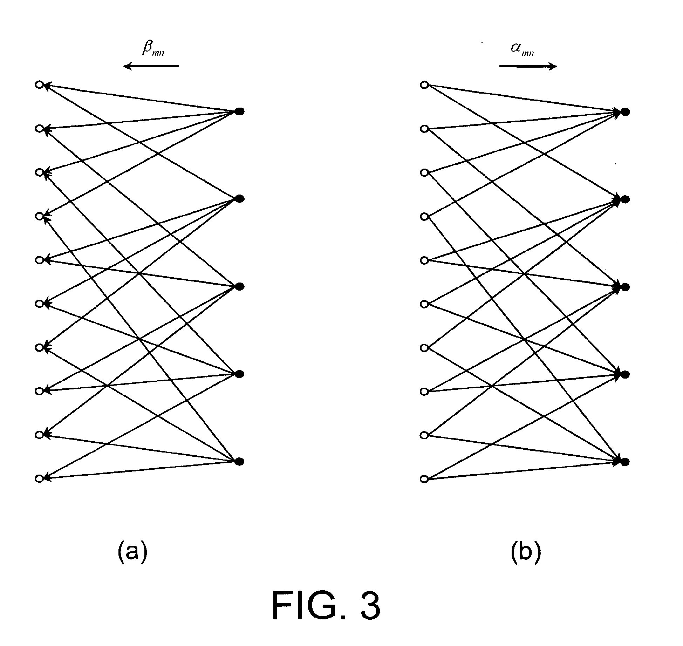

La Fig. 3 représente les premières itérations d'un décodage itératif à passage de messages selon un ordonnancement de type parallèle ;

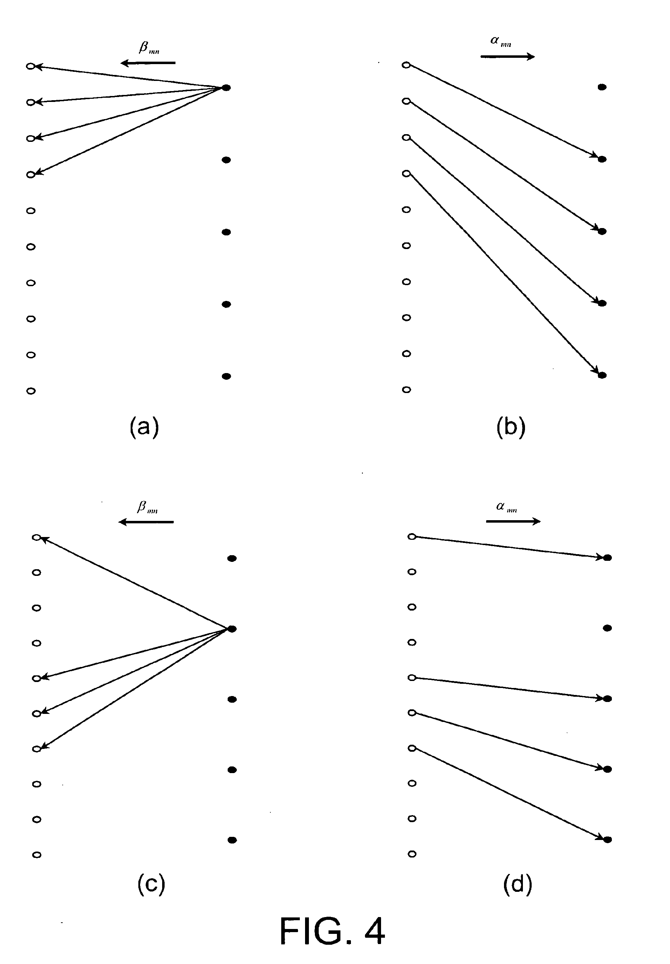

La Fig. 4 représente les premières itérations d'un décodage itératif à passage de messages selon un ordonnancement de type série ;

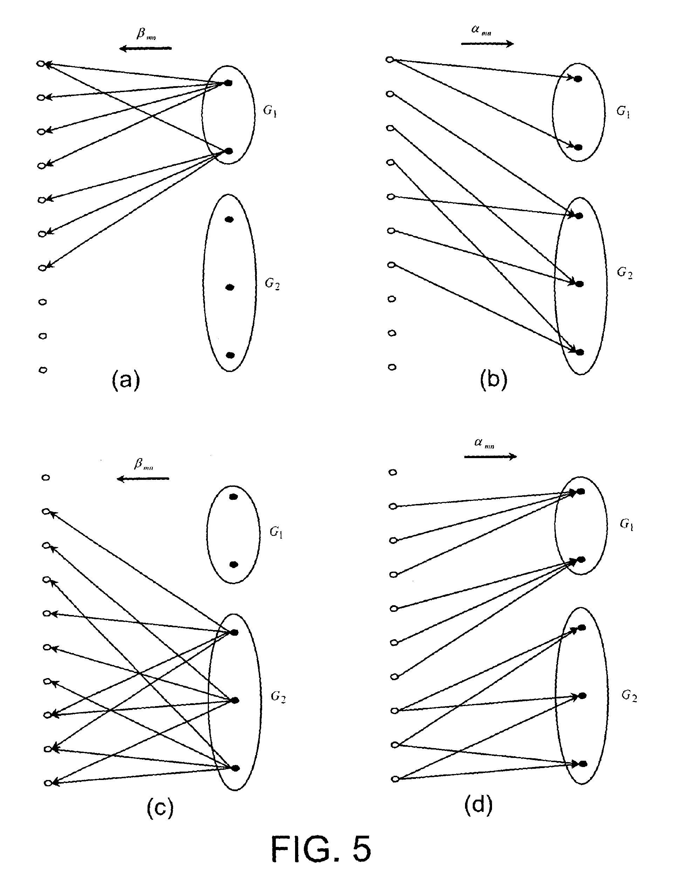

La Fig. 5 représente les premières itérations d'un décodage itératif à passage de messages selon un ordonnancement de type mixte ;

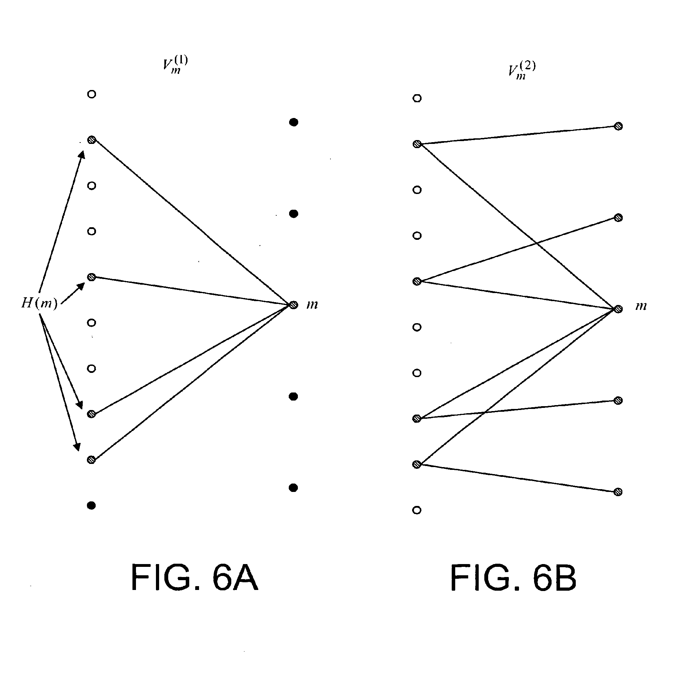

Les Figs. 6A et 6B représentent respectivement le voisinage d'ordre 1 et d'ordre 2 d'un noeud ;

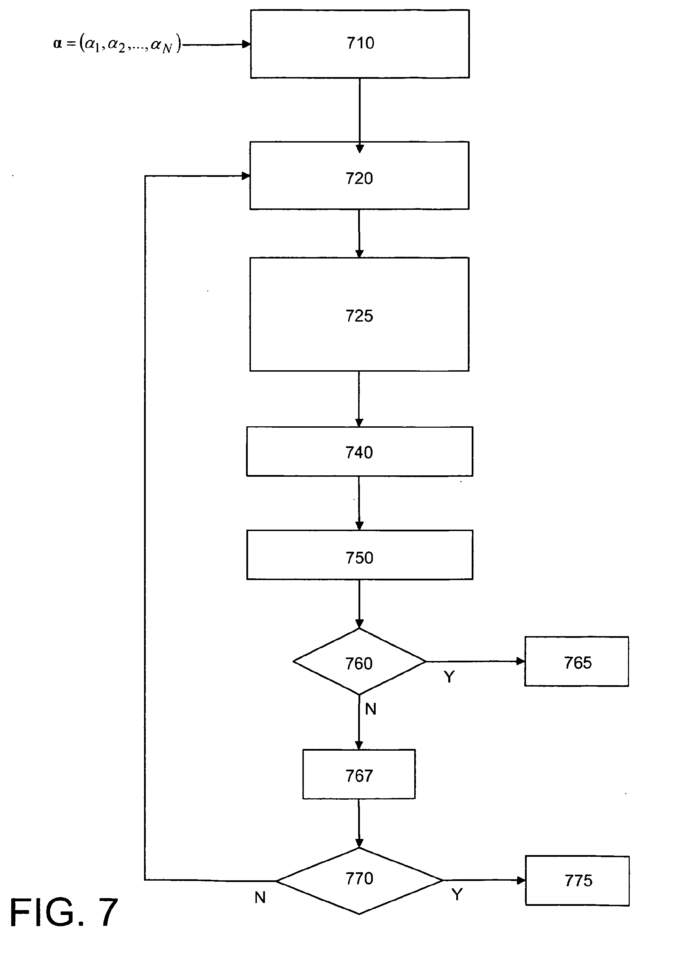

La Fig. 7 représente le principe d'un décodage itératif par passage de messages selon l'invention ;

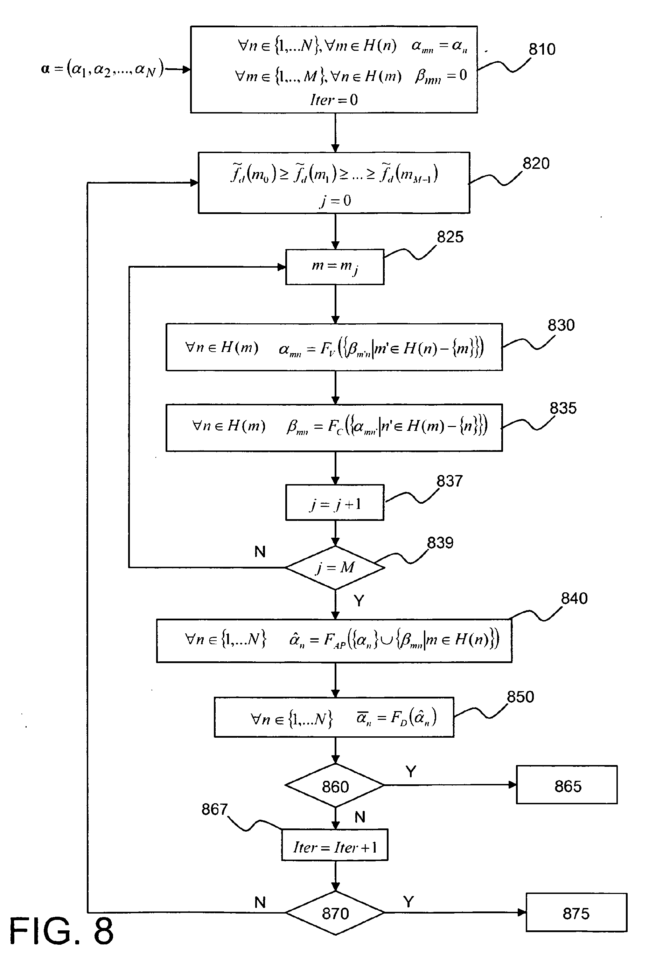

La Fig. 8 représente une méthode de décodage itératif par passage de messages selon un premier mode de réalisation de l'invention ;

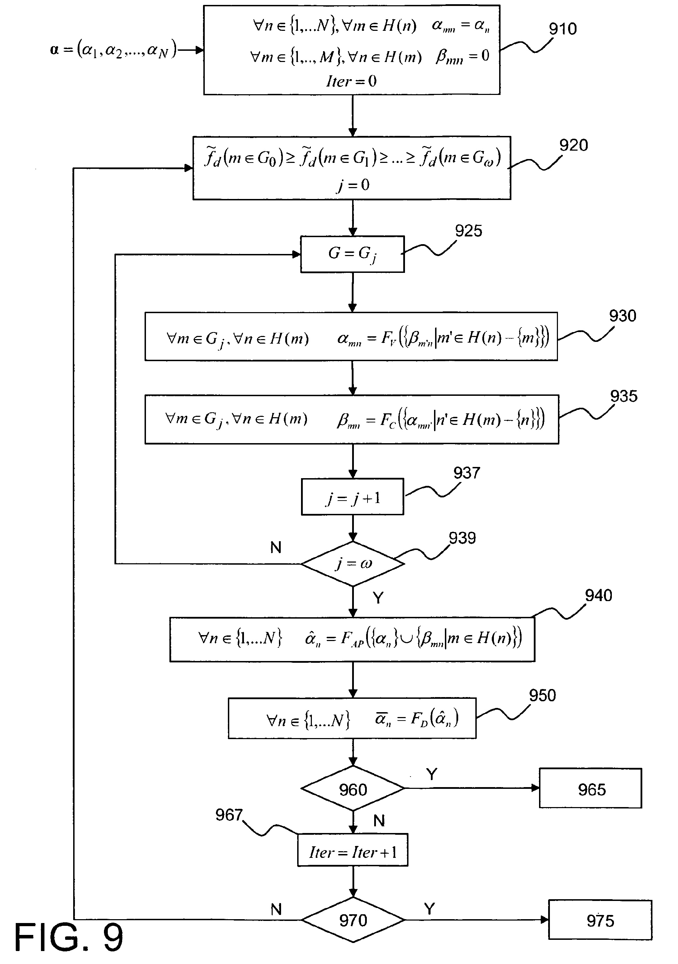

La Fig. 9 représente une méthode de décodage itératif par passage de messages selon un second mode de réalisation de l'invention ;

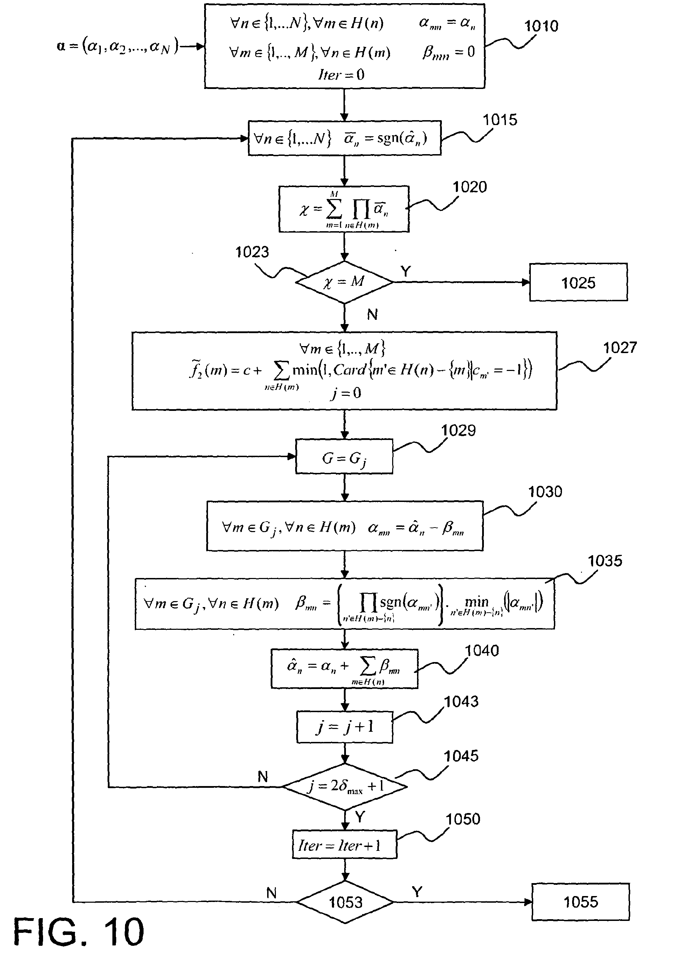

La Fig. 10 représente un exemple d'application de la méthode de décodage selon l'invention pour décoder un code LDPC ;

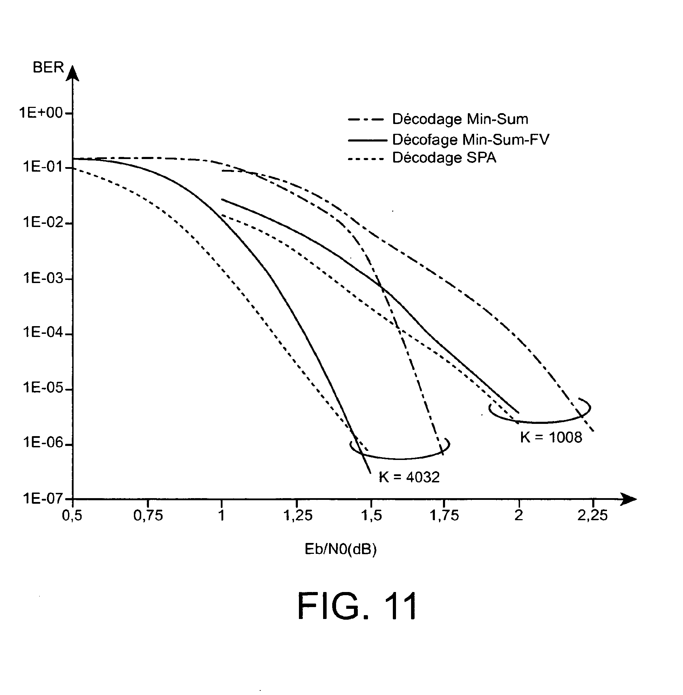

La Fig. 11 indique le taux d'erreur obtenu par la méthode de décodage selon l'invention par comparaison aux méthodes de l'état de la technique, pour un code LDPC particulier.

**EXPOSÉ DÉTAILLÉ DE MODES DE RÉALISATION PARTICULIERS**

On considère à nouveau un code correcteur d'erreurs susceptible d'une représentation par un graphe bipartite avec $N$ variables et $M$ contrôles.

On appelle distance entre deux noeuds $v$, $\mu$ du graphe et l'on note $D(v,\mu)$ la longueur, exprimée en nombre d'arêtes, du plus court chemin reliant ces noeuds à travers le graphe. Compte tenu de la définition même d'un graphe bipartite, on en déduit que la distance entre deux noeuds de même type est un nombre pair et que la distance entre deux noeuds de types différents est un nombre impair.

On définit le voisinage d' ordre $d$ d'un noeud $v$ quelconque d'un graphe $\Gamma$, l'ensemble $V_v^{(d)}$ des noeuds situés à une distance inférieure ou égale à $d$ de $v$, soit :

$$V_v^{(d)} = \left\{\mu \in \Gamma \,\middle|\, D(\mu,v) \leq d\right\} \qquad (21)$$

Ainsi, le voisinage d'ordre 0 d'un noeud n'est autre que le noeud lui-même, le voisinage d'ordre 1 est la réunion du voisinage d'ordre 0 avec l'ensemble des noeuds adjacents à ce noeud, le voisinage d'ordre 2 est la réunion du voisinage d'ordre 1 avec l'ensemble des noeuds adjacents à leur tour aux noeuds de ce dernier, et ainsi de suite. Pour un graphe bipartite, constitué de variables $n$ et de contrôles $m$, les voisinages d'ordre 0 à 2 de ces noeuds sont donnés par :

$$V_n^{(0)} = \left\{n\right\} \quad ; \quad V_n^{(1)} = \left\{n\right\} \bigcup H(n) \quad ; \quad V_n^{(2)} = H(n) \bigcup_{m \in H(n)} H(m) \qquad (22)$$

$$V_m^{(0)} = \{m\} \quad ; \quad V_m^{(1)} = \{m\} \bigcup H(m) \quad ; \quad V_m^{(2)} = H(m) \bigcup_{n \in H(m)} H(n) \qquad (23)$$

On notera que le singleton {n} (resp. {m}) n'apparaît pas dans l'expression de $V_n^{(2)}$ (resp. $V_m^{(2)}$) car il est déjà inclus dans le second terme de l'union compte tenu de la symétrie de la relation d'adjacence.

De manière générale, les voisinages d'un noeud $v$ d'un graphe bipartite peuvent s'obtenir au moyen de la relation de récurrence :

$$V_v^{(d+1)} = \bigcup_{\mu \in V_v^{(d)}} H(\mu) \qquad (24)$$

Afin d'expliciter la notion de voisinage on a représenté en Fig. 6A et 6B les voisinages d'ordre 1 et 2 d'un noeud de contrôle $m$ du graphe de la Fig. 1. Les noeuds appartenant aux dits voisinages ont été indiqués en grisé.

Dans la suite on appellera mesure de fiabilité d'ordre $d$ d'un noeud $v$ de $\Gamma$, une variable $f_d(v)$ dépendant des informations de décodage disponibles au sein du voisinage $V_v^{(d)}$, c'est-à-dire des informations présentes, envoyées ou reçues par les noeuds appartenant audit voisinage, et indiquant le degré de fiabilité local de l'opération de décodage. Nous qualifierons la mesure de « positive » lorsque $f_d(v)$ est d'autant plus élevée que le degré de fiabilité est élevé et de « négative » dans le cas inverse.

L'information de décodage disponible en un noeud $m$ de contrôle comprend, d'une part, la valeur $c_m$, indiquant la vérification ou non du contrôle de parité et, d'autre part, les messages $\beta_{mn}$ transmis aux noeuds de variable adjacents $n \in H(m)$. La valeur $c_m$ ainsi que les messages $\beta_{mn}$ sont porteurs d'une information de fiabilité sur le décodage.

L'information disponible en un noeud $n$ de variable comprend l'information a *priori* $\alpha_n$, l'information a *posteriori* $\hat{\alpha}_n$, les messages d'information extrinsèque $\alpha_{mn}$ à destination des noeuds de contrôle adjacents $m \in H(n)$ ainsi que les valeurs dures $\overline{\alpha}_n$.

Les informations précitées, à l'exception des valeurs dures, sont porteuses d'une information de fiabilité sur le décodage.

De manière générale, si l'on considère les valeurs souples $\beta_{mn}$, $\alpha_{mn}$, $\alpha_n$, $\hat{\alpha}_n$, exprimées sous forme de LLR, le décodage sera considéré d'autant plus fiable que ces dernières seront élevées en valeur absolue.

Nous donnerons ci-après quelques exemples illustratifs et non limitatifs de mesures de fiabilité pour les ordres 0 à 2 :

- mesures de fiabilité d'ordre 0 :

Le voisinage se réduit alors au noeud lui-même. On pourra choisir pour mesure de fiabilité d'ordre zéro d'un noeud $n$ de variable, la fonction :

$$f_0(n) = \left| \hat{\alpha}_n \right| \qquad (25)$$

qui indique le degré de confiance que l'on a dans la valeur dure $\overline{\alpha}_n$.

Pour un noeud de contrôle $m$ on pourra choisir simplement la fonction:

$$\tilde{f}_0(m) = c_m \qquad (26)$$

On comprend en effet que si le contrôle de parité est vérifié ($c_m$ = 1), le décodage sera plus fiable que s'il n'est pas vérifié.

- mesures de fiabilité d'ordre 1 :

On distinguera à nouveau noeud de variable et noeud de contrôle. Pour un noeud de variable on pourra choisir pour mesure de fiabilité d'ordre 1, l'une des fonctions suivantes :

$$f_1(n) = Card\left\{m \in H(n)\middle|c_m = +1\right\} \tag{27}$$

$$f'_1(n) = Card\left\{m \in H(n)\middle|c_m = -1\right\} \tag{27'}$$

$$f_1(n) = Card\left\{m \in H(n)\middle|c_m = +1\right\} - Card\left\{m \in H(n)\middle|c_m = -1\right\} \tag{28}$$

$$f_1(n) = Card\left\{m \in H(n)\middle|c_m = -1\right\} - Card\left\{m \in H(n)\middle|c_m = +1\right\} \tag{28'}$$

$$f_1(n) = \min_{m \in H(n)} \left|\beta_{mn}\right| \tag{29}$$

L'expression (27) représente le nombre de noeuds de contrôle $m$ reliés au noeud de variable $n$ pour lesquels le contrôle de parité est vérifié.
L'expression (28) prend en compte l'irrégularité du code, (c'est-à-dire la possibilité que les noeuds de variable aient des degrés différents) et fait le bilan des contrôles de parité vérifiés et non vérifiés.
Les expressions (27') et (28') sont des mesures négatives correspondant aux mesures positives (27) et (28).
La mesure de fiabilité exprimée en (29) est conservatrice puisqu'elle est fondée sur une minoration de l'information de fiabilité reçue des noeuds de contrôle adjacents.
Pour un noeud $m$ de contrôle, on pourra choisir pour mesure de fiabilité d'ordre 1 l'une des fonctions suivantes :

$$\widetilde{f}_1(m) = \min_{n \in H(m)} \left(\left|\hat{\alpha}_n\right|\right) \tag{30}$$

$$\widetilde{f}_1(m) = \min_{n \in H(m)} \left(\left|\alpha_{mn}\right|\right) \tag{31}$$

**12**

$$\tilde{f}_1(m) = \left( c_m, \min_{n \in H(m)} \left( |\hat{\alpha}_n| \right) \right) \qquad (32)$$

L'expression (30) indique le minimum des fiabilités (informations *a posteriori*) des variables auxquelles le contrôle $m$ est connecté.

L'expression (31) traduit un critère similaire mais porte sur les informations extrinsèques. On notera qu'elle est la duale de l'expression (29).

L'expression (32) représente le produit cartésien de deux informations et par conséquent en tient compte conjointement : la première porte sur la vérification du contrôle de parité et la seconde sur les informations a *posteriori* comme en (30).

- mesures de fiabilité d'ordre 2 :

On pourra choisir pour un noeud $n$ de variable, la fonction suivante :

$$f_2(n) = Card \left\{ m \in H(n) \middle| c_m = -1 \text{ et } \hat{\alpha}_n = \min_{n' \in H(m)} \hat{\alpha}_{n'} \right\} \qquad (33)$$

L'expression (33) représente une mesure négative de fiabilité du décodage : elle indique le nombre de contrôles reliés à la variable $n$ pour lesquels la condition de parité n'est pas vérifiée et tels que la variable $n$ soit la moins fiable parmi toutes les variables adjacentes à ces contrôles. On peut considérer en fait la mesure (33) comme la composition des mesures (27') et (30).

Pour un noeud $m$ de contrôle, on pourra choisir l'une des fonctions suivantes :

$$\tilde{f}_2(m) = Card \left\{ m' \in V_m^{(2)} - \{m\} \middle| c_{m'} = -1 \right\} = \sum_{n \in H(m)} Card \left\{ m' \in H(n) - \{m\} \middle| c_{m'} = -1 \right\}$$

$$(34)$$

$$\tilde{f}_2(m) = \sum_{n \in H(m)} \min \left( 1, Card \left\{ m' \in H(n) - \{m\} \middle| c_{m'} = -1 \right\} \right) \qquad (35)$$

$$\tilde{f}_2(m) = c + \sum_{n \in H(m)} \min \left( 1, Card \left\{ m' \in H(n) - \{m\} \middle| c_{m'} = -1 \right\} \right) \qquad (36)$$

avec $c = 0$ si $c_m = +1$ et $c = \delta_{max} + 1$ si $c_m = -1$ où $\delta_{max}$ est le degré maximal des noeuds de contrôle, c'est-à-dire $\delta_{max} = max(Card(H(m)))$.

L'expression (34) donne le nombre de contrôles de parité non vérifiés dans le voisinage d'ordre 2 de $m$, à l'exclusion de $m$ lui-même. Elle représente une mesure négative de fiabilité du décodage. On notera que la seconde égalité de l'expression (34) n'est vérifiée qu'en l'absence de cycles de longueur 4 dans le voisinage en question. En pratique, on utilise des codes dont les graphes de Tanner présentent des cycles les plus longs possibles, de sorte que l'égalité est généralement vérifiée.

L'expression (35) indique le nombre de variables adjacentes à $m$, connectées à au moins un contrôle non vérifié, à l'exclusion de $m$ lui-même. Elle représente par conséquent une mesure négative de la fiabilité du décodage. Les termes sous le signe somme étant égaux à 0 ou à 1, la valeur de la mesure est comprise entre 0 et $\delta_{max}$.

L'expression (35) ne fait pas de distinction selon que le contrôle de parité est vérifié ou non pour le noeud $m$. Afin de prendre en compte cette information, on a introduit dans l'expression (36) un biais c dont la valeur dépend de la vérification du contrôle m. Pour les valeurs de biais indiquées plus haut ($c= 0,\delta_{max}$ +1), la mesure de fiabilité prend des valeurs comprises entre 0 et $\delta_{max}$ pour un contrôle vérifié et entre ($\delta_{max}$ +1 et $2\delta_{max}$ +1 pour un contrôle vérifié. Notons qu'il s'agit d'une mesure de fiabilité négative au sens défini plus haut, i.e. plus la valeur de $\tilde{f}_2(m)$ est faible plus le contrôle $m$ est fiable. Ainsi, le degré de fiabilité d'un contrôle vérifié est toujours supérieur à celui d'un contrôle non vérifié quelle que soit la valeur de (35).

On notera que certaines des fonctions définies plus haut sont à valeurs entières, notamment celles de (34) à (36). Elles se prêtent donc particulièrement bien à une implémentation au moyen d'un microprocesseur.

De manière importante, certaines des fonctions définies plus haut, notamment celles de (34) à (36) ne font appel qu'à des valeurs dures $c_m$. Etant donné que $$c_m = \prod_{n \in H(m)} \overline{\alpha}_n$$ on constate que la valeur de la puissance de bruit ($\sigma^2$) n'intervient pas dans le calcul de ces fonctions.

L'idée à la base de l'invention est de classer les noeuds du graphe selon leur fiabilité et d'effectuer un décodage par passage de messages selon un schéma de type série ou mixte en commençant par le noeud ou le groupe de noeuds le(s) plus fiable(s). On améliore ainsi considérablement les performances de décodage, tant en termes de vitesse de convergence que de taux d'erreur binaire (BER).

On comprend que les messages transmis par les noeuds les plus fiables sont les mieux à même à contribuer efficacement au décodage des noeuds adjacents. Il y a ainsi une propagation rapide de fiabilité d'une itération à l'autre et de noeud en noeud, et corrélativement, une croissance sensible en valeur absolue des informations extrinsèques, au fur et à mesure des itérations.

La Fig. 7 illustre de manière schématique le principe de décodage selon l'invention. Après une phase d'initialisation 710 qui sera détaillée plus loin, on entre dans une boucle d'itération. On procède en 720 au classement des noeuds de contrôle ou des noeuds de variable du graphe selon leur degré de fiabilité. On supposera ici que l'on classe les noeuds de contrôle, le classement des noeuds de variable conduisant à des étapes symétriques.

En 730, on effectue un traitement série ou bien un traitement mixte. Pour un traitement de type série, on traite les noeuds de contrôle de manière séquentielle et, pour chacun d'entre eux, les noeuds de variable qui lui sont adjacents, en commençant par le noeud de contrôle le plus fiable et en poursuivant par degrés de fiabilité décroissants. Pour un traitement de type mixte, les noeuds de contrôle auront été classés en groupes de fiabilité, le premier groupe étant constitué des noeuds les plus fiables, le second groupe étant constitué de noeuds moins fiables etc. On traite alors de manière parallèle les noeuds de variable et les noeuds de contrôle du premier groupe, puis on passe ensuite au traitement parallèle des noeuds de variable et des noeuds de contrôle du groupe suivant, et l'on continue ainsi de suite jusqu'à épuisement des groupes. Les étapes 740, 750, 760, 765, 767, 770, 775 sont respectivement identiques aux étapes 240, 250, 260, 265, 267, 270, 275 de la Fig. 2 et ne seront donc pas davantage détaillées.

La Fig. 8 représente de manière plus détaillée un mode de réalisation de l'invention utilisant un ordonnancement série.

A l'étape 810, on effectue une initialisation des messages $\alpha_{mn}$ et $\beta_{mn}$. Par exemple, pour chaque couple de variable $n$ et de contrôle $m \in H(n)$ on initialise $\alpha_{mn}$ par $\alpha_{mn} = \alpha_n$. De manière similaire, pour chaque couple de contrôle m et de variable $n \in H(m)$ on initialise $\beta_{mn}$ par $\beta_{mn} = 0$.

On trie ensuite en 820 les contrôles par degrés de fiabilité décroissants en utilisant les mesures de fiabilité $\tilde{f}_d(m)$. Autrement dit, pour une mesure positive, on trie les contrôles de manière à ce que $\tilde{f}_d(m_0) \geq \tilde{f}_d(m_1) \geq ... \geq \tilde{f}_d(m_{M-1})$ et pour une mesure négative on les trie en sens inverse. Si la mesure est un produit cartésien (cf. par exemple (32)) on utilise la relation d'ordre lexicographique ou la relation d'ordre lexicographique inverse suivant que la mesure est négative ou positive. On initialise d'autre part un compteur de noeuds de contrôle, $j = 0$.

On sélectionne en 825 le contrôle courant $m = m_j$ et l'on traite en 830 les variables $n \in H(m)$, autrement dit on calcule $\alpha_{mn} = F_v(\{\beta_{m'n}|m' \in H(n)-\{m\}\})$.

On passe ensuite en 835 à un traitement du contrôle courant $m$, autrement dit on calcule $\beta_{mn} = F_c(\{\alpha_{mn'}|n' \in H(m)-\{n\}\})$ pour $n \in H(m)$.

Selon une variante de réalisation les étapes 830 et 935 sont interverties.

On incrémente le compteur de noeuds de contrôle en 837 et l'on teste en 839 s'ils ont tous été traités. Dans la négative, on reboucle à l'étape 825, sinon l'on poursuit par les étapes 840 à 860, représentant respectivement le calcul d'information a *posteriori,* la décision sur les valeurs dures et la vérification des contrôles de parité. Les étapes 840, 850, 860, 865, 867, 870, 875 sont respectivement identiques aux étapes 240, 250, 260, 265, 267, 270, 275 de la Fig. 2.

Selon un mode alternatif de réalisation, on procède au tri des variables en lieu et place du tri des contrôles. La boucle interne 825 à 839 porte alors sur une variable à la fois et, de même que précédemment, le traitement de la variable courante peut être effectué avant ou après le traitement des contrôles qui lui sont adjacents.

La Fig. 9 illustre un mode de réalisation de l'invention utilisant un ordonnancement mixte.

A l'étape 910, on effectue une initialisation des messages $\alpha_{mn}$ et $\beta_{mn}$ comme en l'étape 810 de la Fig. 8.

En 920, on partitionne l'ensemble des noeuds de contrôle ou des noeuds de variable en groupes, correspondant chacun à une classe de fiabilité différente. Une classe de fiabilité est définie par exemple au moyen d'un intervalle de valeurs d'une mesure de fiabilité. Ce mode de réalisation est particulièrement avantageux lorsque la mesure est à valeurs entières. En effet, on peut alors allouer une tranche à une valeur entière ou à une pluralité de valeurs entières contiguës et ranger les indices des noeuds dans un tableau en fonction de leurs classes respectives. On notera par la suite $\varphi_0, \varphi_1, ..., \varphi_\omega$ les différentes classes de fiabilité, $\varphi_0$ étant la classe de plus haut degré de fiabilité et $\varphi_\omega$ la classe de plus faible degré de fiabilité, et $G_0, G_1, ..., G_\omega$ les groupes de noeuds correspondants. On suppose dans la suite que la partition a été effectuée sur les noeuds de contrôle.

On initialise d'autre part le compteur de classes de fiabilité à *j=0.*

En 925, on sélectionne le groupe de noeuds correspondant à la classe de fiabilité courante $\varphi_j$, soit $G_j$.

A l'étape 930, on effectue en parallèle le traitement des variables $n \in H(m)$, $\forall m \in G_j$, c'est-à-dire que l'on calcule les messages $\alpha_{mn} = F_v(\{\beta m'n | m' \in H(n)-\{m\}\})$, $\forall m \in G_j$, $\forall n \in H(m)$.

A l'étape 935, on effectue en parallèle le traitement des contrôles $m \in G_j$, c'est-à-dire que l'on calcule les messages $\beta_{mn} = F_c(\{\alpha_{mn} | n' \in H(m)- \{n\}\})$, $\forall m \in G_j$, $\forall n \in H(m)$.

Selon une variante de réalisation les étapes 930 et 935 sont interverties.

On incrémente en 937 le compteur de classes et l'on teste en 939 si elles ont toutes été traitées. Dans la négative, on reboucle à l'étape 925, sinon on poursuit par les étapes 940 à 960, représentant respectivement le calcul d'information a *posteriori,* la décision sur les valeurs dures et la vérification des contrôles de parité. Les étapes 940, 950, 960, 965, 967, 970, 975 sont respectivement identiques aux étapes 240, 250, 260, 265, 267, 270, 275 de la Fig. 2.

La Fig. 10 illustre une application particulière de l'invention au décodage d'un code LDPC au moyen d'un ordonnancement mixte, sur la base d'une mesure de fiabilité à valeurs entières. On a choisi ici la mesure négative sur les noeuds de contrôle définie en (36).

A l'étape 1010, on effectue l'initialisation des valeurs souples a *posteriori* $\hat{\alpha}_n$ par les observations correspondantes : $\hat{\alpha}_n = \alpha_n$ et des messages $\beta_{mn}$ par 0.

On initialise également le compteur d'itérations à 0.

En 1015, on prend une décision sur les valeurs dures soit $\overline{\alpha}_n = \text{sgn}(\hat{\alpha}_n)$.

On calcule en 1020 la valeur $\chi = \sum_{m=1}^{M} c_m$ où les $c_m$ sont les contrôles de parité $c_m = \prod_{n \in H(m)} \overline{\alpha}_n$ , $m = 1,...,M$

On teste en 1023 si $\chi = M$, c'est-à-dire si tous les contrôles de parité sont vérifiés. Dans l'affirmative on sort de l'algorithme de décodage en 1025 en fournissant le mot de code. A défaut on poursuit en 1027 par le calcul des mesures de fiabilité des noeuds de contrôle au moyen de la mesure (36). On rappelle que cette mesure prend des valeurs entières parmi $0,1,..,2\delta_{max} +1$ où $\delta_{max}$ est le degré maximal des noeuds de contrôle. Dans le cas présent, on attribue une classe de fiabilité par valeur entière, soit $\varphi_0, \varphi_1, ..., \varphi_\omega$ avec $\omega = 2\delta_{max} +1$ où la classe $\varphi_j$ correspond à la valeur de mesure $j \in \{0,1,..,2\delta_{max} +1\}$.

En 1029, on sélectionne le groupe de noeuds correspondant à la classe de fiabilité courante $\varphi_j$, soit $G_j$.

En 1030, on effectue en parallèle le traitement des variables $n \in H(m)$, $\forall m \in G_j$, c'est-à-dire que l'on calcule les messages , $\alpha_{mn} = \hat{\alpha}_n - \beta_{mn}$ $\forall m \in G_j$.

A l'étape 1035, on effectue en parallèle le traitement des contrôles $m \in G_j$, c'est-à-dire que l'on calcule les messages à destination des variables $n \in H(m)$, $\forall m \in G_j$ soit $\beta_{mn} = \left( \prod_{n' \in H(m)-\{n\}} \text{sgn}(\alpha_{mn'}) \right) . \Phi \left( \sum_{n' \in H(m)-\{n\}} \Phi(|\alpha_{mn'}|) \right)$ ,

pour un traitement SPA et $\beta_{mn} = \left( \prod_{n' \in H(m)-\{n\}} \text{sgn}(\alpha_{mn'}) \right) . \min_{n' \in H(m)-\{n\}} (|\alpha_{mn'}|)$ pour un traitement simplifié de type Min-Sum comme indiqué ici sur la Figure. On calcule ensuite les informations a *posteriori* en 1040 grâce à

$$\hat{\alpha}_n = \alpha_n + \sum_{m \in H(n)} \beta_{mn} .$$

On notera qu'une partie des contrôles $m \in H(n)$ intervenant dans la sommation peuvent ne pas faire partie du groupe $G_j$ et que donc les messages $\beta_{mn}$ qui proviennent de ces contrôles n'ont pas été recalculés en 1035. En outre, la variable $n$ étant adjacente à plusieurs contrôles $m \in H(n),$ le calcul de $\hat{\alpha}_n$ se fera plusieurs fois au fur et à mesure que l'on traite les contrôles de $H(n)$. Afin d'éviter que la somme en 1040 ne soit calculée plusieurs fois et qu'à chaque fois certains messages $\beta_{mn}$ n'ayant pas varié ne soient recalculés, on pourra avantageusement remplacer les étapes 1035 et 1040 par une étape comprenant les opérations suivantes :

$$\forall m \in G_j, \forall n \in H(m)$$

- soustraction de l'ancien message, soit :

$$\hat{\alpha}_n = \hat{\alpha}_n - \beta_{mn}$$

- calcul du nouveau message, soit :

$$\beta_{mn} = \left( \prod_{n' \in H(m)-\{n\}} \mathrm{sgn}(\alpha_{mn'}) \right) . \min_{n' \in H(m)-\{n\}} \left( |\alpha_{mn'}| \right)$$

- actualisation de l'information a *posteriori* par addition du nouveau message :

$$\hat{\alpha}_n = \hat{\alpha}_n + \beta_{mn}$$

De cette manière on met à jour l'information a posteriori $\hat{\alpha}_n$ au fur et à mesure que l'on calcule les nouveaux messages envoyés par les contrôles $m \in H(n)$ à la variable $n$. Cela permet de réduire sensiblement le nombre d'opérations effectuées pour le calcul des informations a *posteriori.*

On incrémente ensuit en 1043 le compteur de classes de fiabilité et l'on teste en 1045 si toutes les classes ont été traitées. Dans la négative, on retourne à l'étape 1029 pour traiter la classe de fiabilité suivante. Dans l'affirmative, on incrémente le compteur d'itérations en 1050. En 1053, on teste si le critère d'arrêt est vérifié, c'est-à-dire si le nombre maximal d'itérations est atteint. Si c'est le cas, on sort de la boucle en 1055 en concluant à l'échec du décodage. A défaut, on reboucle à l'étape 1015 pour une nouvelle itération.

On remarque qu'en Fig. 10, les étapes de décision sur les valeurs dures ainsi que de vérification du contrôle de parité précèdent celles de calcul de fiabilité et de traitement des noeuds. Ceci est dû au fait que la mesure de fiabilité utilisée ici (expression (36)) fait appel aux décisions dures $c_m$ et nécessite par conséquent leur calcul préalable.

L'algorithme illustré en Fig. 10 ne présente qu'une faible complexité additionnelle par rapport aux algorithmes SPA ou Min-Sum de l'état de la technique. En contrepartie, l'ordonnancement par fiabilité de voisinage accélère la convergence et permet d'atteindre un taux d'erreur (BER) plus faible pour un même rapport signal à bruit (SNR). Alternativement, pour un même taux d'erreur de consigne, la méthode de décodage selon l'invention permet d'utiliser des codes à plus faible gain de codage.

La Fig. 11 permet de comparer les performances en termes de taux d'erreur binaire (BER) des algorithmes Min-Sum et SPA conventionnels avec l'algorithme Min-Sum utilisant un ordonnancement par fiabilité de voisinage, noté Min-Sum-FV, ce pour une plage importante de rapports signal à bruit. Les codes utilisés sont des codes LDPC irréguliers [1008,2016] et [4032,8064], et donc de rendement 1/2. Le nombre d'itérations effectuées est égal à 200 pour les trois algorithmes.

On remarque que l'algorithme Min-Sum-FV selon l'invention surpasse l'algorithme SPA conventionnel bien que sa complexité soit sensiblement moindre.

Dans la méthode de décodage selon l'invention telle que représentée en Figs. 7 à 10 on a supposé que l'on utilisait l'ordonnancement par fiabilité de voisinage pendant toute la durée du décodage. Selon une variante, on peut n'appliquer cet ordonnancement que lors des premières itérations, de manière à débruiter les observations, puis basculer sur un traitement conventionnel. Le critère de basculement peut être libellé en un nombre d' itérations $Iter_f$ ou bien,

avantageusement, être basé sur une comparaison en valeur absolue des informations extrinsèques avec un seuil de référence. Par exemple, dès que dans le décodage itératif :

$$\min_{n=1,\ldots,N} \left| \hat{\alpha}_n - \alpha_n \right| > T_f \qquad (37)$$

où $T_f$ représente un seuil minimal de fiabilité, on pourra revenir à un traitement Min-Sum ou SPA conventionnel. Cette variante permet d'éviter le tri ou le classement des noeuds dès que les valeurs décodées sont suffisamment fiables et que la convergence est assurée.

La présente invention s'applique au décodage de codes correcteurs d'erreurs susceptibles de représentation par graphe bipartite, notamment des codes LDPC ou des turbocodes. Elle peut être utilisée dans le domaine de l'enregistrement de données ou des télécommunications, en particulier pour les systèmes de télécommunications utilisant déjà des codes LDPC, par exemple ceux obéissant aux normes IEEE 802.3a (Ethernet 10Gbits/s), DVB-S2 (diffusion de vidéo par satellite), IEEE 802.16 (WiMAX), ou susceptibles de les utiliser, par exemple les systèmes obéissant aux normes IEEE 802.11 (WLAN) et IEEE 802.20 (Mobile Broadband Wireless Access).

## Revendications

1. Méthode de décodage itératif de type à passage de messages pour décoder un code correcteur d'erreurs susceptible de représentation par un graphe bipartite comprenant une pluralité de noeuds de variable et une pluralité de noeuds de contrôle, **caractérisée en ce qu'**à chaque itération d'une pluralité d'itérations de décodage :

   - on effectue un classement (720) des noeuds de variable ou bien des noeuds de contrôle en fonction des degrés de fiabilité respectifs des informations de décodage disponibles en des voisinages ($V_n^{(d)}, V_m^{(d)}$) de ces noeuds, un noeud possédant un degré de fiabilité élevé étant classé avant un noeud possédant un faible degré de fiabilité ;
   - les noeuds ainsi classés passent (725) chacun au moins un message ($\alpha_{mn}$, $\beta_{mn}$) à un noeud adjacent, dans l'ordre défini par ledit classement.

2. Méthode de décodage selon la revendication 1, **caractérisée en ce que** ledit classement comprend, pour chaque noeud à classer, le calcul d'une mesure de fiabilité ($f_d(n)$, $\tilde{f}_{d'}(m)$) des informations présentes, envoyées ou reçues par les noeuds situés à moins d'une distance prédéterminée ($d$) de ce dernier au sein du graphe bipartite, et le tri des valeurs des mesures ainsi obtenues.

3. Méthode de décodage selon la revendication 2, **caractérisée en ce que**, pour chaque itération de ladite pluralité, elle opère séquentiellement sur les noeuds classés dans l'ordre défini par ledit classement, et que, pour chaque noeud classé (825), on calcule les messages à destination des noeuds qui lui sont adjacents (835) et, pour chacun desdits noeuds adjacents, les messages à destination des noeuds eux-mêmes adjacents à celui-ci (830).

4. Méthode de décodage selon la revendication 1, **caractérisée en ce que** ledit classement comprend, pour chaque noeud à classer, le calcul d'une mesure de fiabilité ($f_d(n)$, $\tilde{f}(m)$) des informations présentes, envoyées ou reçues par les noeuds situés à moins d'une distance prédéterminée ($d$) de ce noeud au sein du graphe bipartite, et que l'on groupe les noeuds par intervalles de valeurs de ladite mesure.

5. Méthode de décodage selon la revendication 4, **caractérisée en ce que** la mesure de fiabilité est à valeurs entières et que pour chacune desdites valeurs entières on stocke dans une zone de mémoire qui lui est associée les indices des noeuds dont la mesure de fiabilité est égale à cette valeur.

6. Méthode de décodage selon la revendication 4 ou 5, **caractérisée en ce que**, pour chaque itération de ladite pluralité, on opère séquentiellement sur les groupes de noeuds dans l'ordre défini par ledit classement, et que, pour chaque groupe de noeuds ($G_j$), on calcule les messages à destination des noeuds qui leur sont adjacents (935) et, pour chacun desdits noeuds adjacents, les messages à destination des noeuds eux-mêmes adjacents à ces derniers (930).

**7.** Méthode de décodage selon l'une des revendications précédentes, **caractérisée en ce que** chaque itération de ladite pluralité comprend en outre, pour chaque noeud de variable dudit graphe bipartite; une étape de calcul (740,840,940) d'une information a *posteriori* ($\hat{\alpha}_n$) en fonction d'une information a *priori* ($\alpha_n$) déjà présente dans ce noeud et des messages reçus ($\beta_{mn}$) par ce noeud en provenance des noeuds de contrôle adjacents.

**8.** Méthode de décodage selon la revendication 7, **caractérisée en ce que** l'étape de calcul d'information a *posteriori* est suivie d'une étape de décision (750,850,950) sur la valeur dure ($\overline{\alpha}_n$) de ladite variable.

**9.** Méthode de décodage selon la revendication 8, **caractérisée en ce qu'**on teste (760,860,960) si les valeurs dures des variables ainsi obtenues vérifient les contrôles de parité associés à tous les noeuds de contrôle du graphe et que, dans l'affirmative, on fournit comme mot décodé le mot constitué desdites valeurs dures.

**10.** Méthode de décodage selon l'une des revendications précédentes, **caractérisée en ce que** le classement est interrompu après un nombre d'itérations de décodage prédéterminé *(Iter_f),* la méthode de décodage poursuivant ensuite ses itérations de décodage en absence dudit classement desdits noeuds de variables ou bien desdits noeuds de contrôle.

**11.** Méthode de décodage selon la revendication 7, **caractérisée en ce que** le classement est interrompu si le minimum, en valeur absolue, des différences entre les valeurs a *posteriori* et des valeurs a *priori* desdites variables est supérieur à une valeur de seuil prédéterminé ($T_f$), la méthode de décodage poursuivant ensuite ses itérations de décodage en absence dudit classement desdits noeuds de variables ou bien desdits noeuds de contrôle.

**12.** Méthode de décodage selon l'une des revendications précédentes, **caractérisée en ce que** ledit code correcteur d'erreurs est un turbocode.

**13.** Méthode de décodage selon l'une des revendications 1 à 11, **caractérisée en ce que** ledit code correcteur d'erreurs est un code LDPC *(K,N)* représenté par un graphe bipartite à *N* noeuds de variable et *M = N-K* noeuds de contrôle.

**14.** Méthode de décodage selon la revendication 13, **caractérisée en ce que** le message $\beta_{mn}$ d'un noeud de contrôle d'indice $m \in \{1,..,M\}$ à un noeud de variable d'indice $n \in \{1,..,N\}$ est calculé par :

$$\beta_{mn} = \left( \prod_{n' \in H(m)-\{n\}} \text{sgn}(\alpha_{mn'}) \right) . \Phi\left( \sum_{n' \in H(m)-\{n\}} \Phi(|\alpha_{mn'}|) \right)$$

où $\alpha_{mn'}$ désigne le message du noeud de variable d'indice *n'* au noeud de contrôle d'indice *m ,* H(m) l'ensemble des noeuds de variable adjacents au noeud de contrôle d'indice *m*, sgn(*x*)=1 si *x* est positif et sgn(*x*)=-1 sinon, et

$$\Phi(x) = \ln\left( \frac{e^x + 1}{e^x - 1} \right) . \, .$$

**15.** Méthode de décodage selon la revendication 13, **caractérisée en ce que** le message $\beta_{mn}$ d'un noeud de contrôle d'indice $m \in \{1,..,M\}$ à un noeud de variable d'indice $n \in \{1,..,N\}$ est calculé par :

$$\beta_{mn} = \left( \prod_{n' \in H(m)-\{n\}} \text{sgn}(\alpha_{mn'}) \right) . \min_{n' \in H(m)-\{n\}} (|\alpha_{mn'}|)$$

où $\alpha_{mn'}$ désigne le message du noeud de variable d'indice *n'* au noeud de contrôle d'indice *m, H(m)* l'ensemble des noeuds de variable adjacents au noeud de contrôle d'indice $m$, sgn($x$)=1 si $x$ est positif et sgn($x$) = -1 sinon.

**16.** Méthode de décodage selon les revendications 5 et 15, **caractérisée en ce que** le classement porte sur les noeuds de contrôle, **en ce que** ladite distance prédéterminée est égale à 2 et **en ce que** la mesure de fiabilité d'un noeud de contrôle d'indice $m$ est calculée par :

$$\tilde{f}_2(m) = c + \sum_{n \in H(m)} \min\left(1, Card\left\{m' \in H(n) - \{m\}\middle|c_{m'} = -1\right\}\right)$$

où $H(m)$ désigne l'ensemble des noeuds de variable adjacents au noeud de contrôle d'indice $m$ , $H(n)$ l'ensemble des noeuds de contrôle adjacents au noeud de variable d'indice $n$, $Card(.)$ désigne le cardinal d'un ensemble, avec $c = 0$ si $c_m = +1$ et $c = \delta_{max} +1$ si $c_m = -1$ où $\delta_{max}$ est le degré maximal des noeuds de contrôle dans le graphe bipartite, et où $c_m = +1$ / $c_m = -1$ signifient respectivement que le contrôle de parité est vérifié/n'est pas vérifié, pour le noeud de contrôle d'indice $m$.

**17.** Programme d'ordinateur comprenant des moyens logiciels adaptés à mettre en oeuvre les étapes de la méthode de décodage selon l'une des revendications précédentes, lorsqu'il est exécuté par un ordinateur.

## Claims

**1.** Iterative method by message passing for decoding of an error correction code that can be represented by a bipartite graph comprising a plurality of variable nodes and a plurality of check nodes, **characterised in that** for each iteration in a plurality of decoding iterations:

- variable nodes or check nodes are classified (720) as a function of the corresponding degrees of reliability of decoding information available in the neighbourhoods ( $V_n^{(d)}, V_m^{(d)}$ ) of these nodes, a node with a high degree of reliability being classified before a node with a low degree of reliability;
- each node thus classified (725) passes at least one message ($\alpha_{mn}$, $\beta_{mn}$) to an adjacent node, in the order defined by said classification.

**2.** Decoding method according to claim 1, **characterised in that** for each node to be classified, said classification includes the calculation of a measurement of the reliability $(f_d(n), \tilde{f}_d(m))$ of the information present, sent or received by nodes located less than a predetermined distance ($d$) from this node in the bipartite graph, and sorting of the measurement values thus obtained.

**3.** Decoding method according to claim 2, **characterised in that**, for each iteration of said plurality, the classified nodes are processed sequentially in the order defined by said classification, and that, for each classified node (825), messages addressed to nodes adjacent to it are calculated (835), and for each said adjacent node, messages to nodes adjacent to said adjacent node are calculated (830).

**4.** Decoding method according to claim 1, **characterised in that** for each node to be classified, said classification includes the calculation of the reliability measurement $(f_d(n), \tilde{f}_d(m))$ of the information present, sent or received by nodes located at not more than a predetermined distance ($d$) from this node in the bipartite graph, and **in that** nodes are grouped in intervals of values of said measurement.

**5.** Decoding method according to claim 4, **characterised in that** the reliability measurement uses integer values and **in that**, for each said integer value, indexes of nodes for which the reliability measurement is equal to this value are stored in a memory zone associated with it.

**6.** Decoding method according to claim 4 or 5, **characterised in that**, for each iteration of said plurality, node groups are processed sequentially in the order defined by said classification, and **in that**, for each node group ($G_j$), messages to nodes adjacent to the nodes in the group are calculated (935) and, for each of said adjacent nodes, messages to nodes themselves adjacent to said adjacent nodes are also calculated (930).

7. Decoding method according to one of the previous claims, **characterised in that** for each variable node in said bipartite graph, each iteration of said plurality also comprises a step (740,840,940) to calculate an *a posteriori* information ($\hat{\alpha}_n$) as a function of an *a priori* information ($\alpha_n$) already present in this node, and messages ($\beta_{mn}$) received by this node from the adjacent check nodes.

8. Decoding method according to claim 7, **characterised in that** the *a posteriori* information calculation step is followed by a decision step (750,850,950) about the hard value ($\bar{\alpha}_n$) of said variable.

9. Decoding method according to claim 8, **characterised in that** the next step (760,860,960) tests if the hard values of variables thus obtained satisfy the parity checks associated with all check nodes in the graph and if so, the word composed of said hard values is provided as the decoded word.

10. Decoding method according to one of the previous claims, **characterised in that** the classification is interrupted after a predetermined number of decoding iterations *(Iter$_f$)*, the decoding method then continuing its decoding iterations in the absence of said classification of said variable nodes or said check nodes.

11. Decoding method according to claim 7, **characterised in that** the classification is interrupted if the minimum of the absolute value of differences between the *a posteriori* values and *a priori* values of said variables is greater than a predetermined threshold value *(T$_f$)*, the decoding method then continuing its decoding iterations in the absence of said classification of said variable nodes or said check nodes.

12. Decoding method according to one of the previous claims, **characterised in that** said error correction code is a turbocode.

13. Decoding method according to one of claims 1 to 11, **characterised in that** said error correction code is an LDPC code *(K,N)* represented by a bipartite graph with *N* variable nodes and *M = N - K* check nodes.

14. Decoding method according to claim 13,
**characterised in that** the $\beta_{mn}$ message from a check node with index $m \in \{1,..,M\}$ to a variable node with index $n \in \{1,..,N\}$ is calculated as follows:

$$\beta_{mn} = \left( \prod_{n' \in H(m)-\{n\}} \mathrm{sgn}(\alpha_{mn'}) \right) \Phi \left( \sum_{n' \in H(m)-\{n\}} \Phi(|\alpha_{mn'}|) \right)$$

where $\alpha_{mn'}$ denotes the message from the variable node with index *n'* to the check node with index *m*, *H(m)* represents all variable nodes adjacent to the check node with index *m*, sgn(*x*)=1 if *x* is positive and sgn(*x*) = -1 otherwise, and $\Phi(x) = \ln\left( \dfrac{e^x + 1}{e^x - 1} \right)$.

15. Decoding method according to claim 13, **characterised in that** the message $\beta_{mn}$ from a check node with index $m \in \{1,..,M\}$ to a variable node with index $n \in \{1,..,N\}$ is calculated as follows:

$$\beta_{mn} = \left( \prod_{n' \in H(m)-\{n\}} \mathrm{sgn}(\alpha_{mn'}) \right) \min_{n' \in H(m)-\{n\}} (|\alpha_{mn'}|)$$

where $\alpha_{mn'}$ denotes the message from the variable node with index *n'* to the check node with index *m*, *H(m)* represents all variable nodes adjacent to the check node with index *m*, sgn(*x*)=1 if *x* is positive and sgn(*x*) = -1 otherwise.

**16.** Decoding method according to claims 5 and 15, **characterised in that** the classification applies to check nodes, and **in that** said predetermined distance is equal to 2 and **in that** the reliability measurement of a check node with index *m* is then calculated as follows:

$$\widetilde{f}_2(m) = c + \sum_{n \in H(m)} \min\left(1, Card\left\{m' \in H(n) - \{m\} \middle| c_{m'} = -1\right\}\right)$$

where *H(m)* denotes the set of variable nodes adjacent to the check node with index *m, H(n)* represents the set of check nodes adjacent to the variable node with index *n, Card(.)* denotes the cardinal of a set, where $c = 0$ if $c_m = +1$ and $c = \delta_{max} +1$ if $c_m = -1$ where $\delta_{max}$ is the maximum degree of check nodes in the bipartite graph, and where $c_m = +1$ / $c_m = -1$ mean that the parity check is / is not satisfied respectively for the check node with index *m*.

**17.** Computer program comprising software means adapted to implementing steps in the decoding method according to one of the previous claims, when it is run by a computer.

**Patentansprüche**

**1.** Iteratives Decodierverfahren des Message-Passing-Typs zur Decodierung eines Fehlerkorrekturcodes, geeignet zur Darstellung durch einen zweiteiligen Graphen mit einer Vielzahl Variablenknoten und einer Vielzahl Kontrollknoten,
**dadurch gekennzeichnet, dass** - bei jeder Iteration einer Vielzahl von Decodieriterationen:

- man eine Klassifizierung (720) der Variablenknoten oder auch der Kontrollknoten in Abhängigkeit von den respektiven Zuverlässigkeitsgraden der verfügbaren Decodierinformationen in Nachbarschaften $(V_n^{(d)}, V_m^{(d)})$ dieser Knoten durchführt, wobei ein einen hohen Zuverlässigkeitsgrad besitzender Knoten vor einem einen niedrigen Zuverlässigkeitsgrad besitzenden Knoten klassifiziert wird;
- jeder der so klassifizierten Knoten wenigstens eine Nachricht $(\alpha_{mn}, \beta_{mn})$ an einen benachbarten Knoten weitergibt (725), in der durch die genannte Klassifizierung definierten Reihenfolge.

**2.** Decodierverfahren nach Anspruch 1, **dadurch gekennzeichnet, dass** die genannte Klassifizierung für jeden zu klassifizierenden Knoten die Berechnung eines Zuverlässigkeitsmaßes $(f_d(n), \widetilde{f}_d(m))$ der präsenten, durch die unterhalb eines vorherbestimmten Abstands (d) von diesem Knoten inmitten des zweitteiligen Graphen befindlichen Knoten gesendeten oder empfangenen Informationen umfasst.

**3.** Decodierverfahren nach Anspruch 2, **dadurch gekennzeichnet, dass** es - für jede Iteration der genannten Vielzahl - die klassifizierten Knoten in der durch die genannte Klassifizierung definierten Reihenfolge sequentiell bearbeitet, und dass man für jeden klassifizierten Knoten (825) berechnet: die für die ihm benachbarten Knoten (835) bestimmten Nachrichten und, für jeden der genannten benachbarten Knoten, die für die diesem (830) selbst benachbarten Knoten bestimmten Nachrichten.

**4.** Decodierverfahren nach Anspruch 1, **dadurch gekennzeichnet, dass** die genannte Klassifizierung für jeden zu klassifizierenden Knoten die Berechnung eines Zuverlässigkeitsmaßes $(f_d(n), \widetilde{f}_d(m))$ der präsenten, durch die unterhalb eines vorherbestimmten Abstands (d) von diesem Knoten inmitten des zweitteiligen Graphen befindlichen Knoten gesendeten oder empfangenen Informationen umfasst, und dass man die Knoten entsprechend Intervallen von Werten des genannten Maßes gruppiert.

**5.** Decodierverfahren nach Anspruch 4, **dadurch gekennzeichnet, dass** das Zuverlässigkeitsmaß Gesamt- bzw. Ganzzahlwerte umfasst, und dass man für jeden der genannten Werte in einer ihm zugeordneten Speicherzone die Indizes der Knoten speichert, deren Zuverlässigkeitsmaß gleich diesem Wert ist.

**6.** Decodierverfahren nach Anspruch 4 oder 5, **dadurch gekennzeichnet, dass** man - für jede Iteration der genannten Vielzahl - die Knotengruppen in der durch die genannte Klassifizierung definierten Reihenfolge sequentiell bearbeitet, und dass man für jede Knotengruppe ($G_j$) die für die ihr benachbarten Knoten bestimmten Nachrichten (935) und für jeden der genannten benachbarten Knoten die für die ihrerseits diesen Letzteren benachbarten Knoten bestimmten Nachrichten (930) berechnet.

7. Decodierverfahren nach einem der vorangehenden Ansprüche, **dadurch gekennzeichnet, dass** jede Iteration der genannten Vielzahl außerdem für jeden Variablenknoten des genannten zweiteiligen Graphen umfasst: einen Schritt (740 ,840, 940) zur Berechnung einer a-posteriori-Information ($\hat{\alpha}_n$) in Abhängigkeit von einer in diesem Knoten schon präsenten a-priori-Information ($\alpha_n$) und von durch diesen Knoten schon empfangenen, von benachbarten Kontrollknoten stammenden Nachrichten ($\beta_{mn}$).

8. Decodierverfahren nach Anspruch 7, **dadurch gekennzeichnet, dass** auf den Schritt zur Berechnung der a-posteriori-Information ein Schritt (750, 850, 950) zur Entscheidung über den harten Wert ($\bar{\alpha}_n$) der genannten Variablen.

9. Decodierverfahren nach Anspruch 8, **dadurch gekennzeichnet, dass** man prüft (760, 860, 960), ob die harten Werte der so erhaltenen Variablen die mit allen Kontrollknoten des Graphen verbundenen Paritätsprüfungen verifizieren, und man, bei Bestätigung, als decodiertes Wort das durch die genannten harten Werte gebildete Wort liefert.

10. Decodierverfahren nach einem der vorangehenden Ansprüche, **dadurch gekennzeichnet, dass** die Klassifizierung nach einer bestimmten Anzahl von Iterationen ($Iter_f$) unterbrochen wird, wobei das Decodierverfahren anschließend seine Decodieriterationen ohne die genannte Klassifizierung der genannten Variablenknoten oder auch der genannten Kontrollknoten fortsetzt.

11. Decodierverfahren nach Anspruch 7, **dadurch gekennzeichnet, dass** die Klassifizierung unterbrochen wird, wenn das Minimum - als Absolutwert - der Differenzen zwischen den *a-posteriori*-Werten und den *a-priori*-Werten größer ist als ein vorherbestimmter Schwellenwert ($T_f$), wobei das Decodierverfahren anschließend seine Decodieriterationen ohne die genannte Klassifizierung der genannten Variablenknoten oder auch der genannten Kontrollknoten fortsetzt.

12. Decodierverfahren nach einem der vorangehenden Ansprüche, **dadurch gekennzeichnet, dass** der genannte Fehlerkorrekturcode ein Turbocode ist.

13. Decodierverfahren nach einem der Ansprüche 1 bis 11, **dadurch gekennzeichnet, dass** der genannte Fehlerkorrekturcode ein LDPC-Code ($K,N$) ist, dargestellt durch einen zweiteiligen Graphen mit N Variablenknoten und $M = N - K$ Kontrollknoten.

14. Decodierverfahren nach Anspruch 13, **dadurch gekennzeichnet, dass** die Nachricht ($\beta_{mn}$) eines Kontrollknotens mit dem Index $m \in \{1,...,M\}$ an einen Variblenknoten mit dem Index $n \in \{1, ... ,N\}$ berechnet wird durch:

$$\beta_{mn} = \left( \prod_{n' \in H(m)-\{n\}} sgn(\alpha_{mn'}) \right) \Phi \left( \sum_{n' \in H(m)-\{n\}} \Phi(|\alpha_{mn'}|) \right)$$

wo $\alpha_{mn'}$ die Nachricht des Variablenknotens mit dem Index $n'$ an den Kontrollknoten mit dem Index $m$ und $H(m)$ die Gesamtheit der den Kontrollknoten mit dem Index $m$ benachbarten Variablenknoten bezeichnet, wobei sgn($x$)=1 ist, wenn $x$ positiv ist, und sgn($x$)=-1 wenn nicht, und $\Phi(x) = ln\left( \dfrac{e^x + 1}{e^x - 1} \right)$

15. Decodierverfahren nach Anspruch 13, **dadurch gekennzeichnet, dass** die Nachricht ($\beta_{mn}$) eines Kontrollknotens mit dem Index $m \in \{1,...,M\}$ an einen Variblenknoten mit dem Index $n \in \{1,...,N\}$ berechnet wird durch:

$$\beta_{mn} = \left( \prod_{n' \in H(m)-\{n\}} sgn(\alpha_{mn'}) \right) \min_{n' \in H(m)-\{n\}} (|\alpha_{mn'}|)$$

wo $\alpha_{mn'}$ die Nachricht des Variablenknotens mit dem Index $n'$ an den Kontrollknoten mit dem Index $m$ und $H(m)$ die Gesamtheit der den Kontrollknoten mit dem Index $m$ benachbarten Variablenknoten bezeichnet, wobei sgn($x$)=1 ist, wenn $x$ positiv ist, und sgn($x$)=-1 wenn nicht.

16. Decodierverfahren nach Anspruch 5 und 15, **dadurch gekennzeichnet, dass** die Klassifizierung die Kontrollknoten betrifft und dass der genannte vorherbestimmte Abstand gleich 2 ist, und **dadurch**, dass das Zuverlässigkeitsmaß eines Knotens mit dem Index $m$ berechnet wird durch:

$$\widetilde{f}_2(m) = c + \sum_{n \in H(m)} min(1, Card\{m' \in H(n)-\{m\} \mid c_{m'} = -1\})$$

wo $H(m)$ die Gesamtheit der den Kontrollknoten mit dem Index $m$ benachbarten Variablenknoten bezeichnet und $H(n)$ die Gesamtheit der den Variablenknoten mit dem Index $n$ benachbarten Kontrollknoten bezeichnet, $Card.(.)$ die Kardinalzahl bezeichnet, mit $c$=0 wenn $c_m$=+1 und $c$=$\delta_{max}$+1, wenn $c_m$=-1, wo $\delta_{max}$ der maximale Grad der Kontrollknoten in dem zweiteiligen Graphen ist, und wo $c_m$=+1 / $c_m$=-1 jeweils bedeuten, dass für den Kontrollknoten mit dem Index $m$ die Paritätsprüfung verifiziert ist / nicht verifiziert ist.

17. Computerprogramm, Software-Tools umfassend, fähig die Schritte des Decodierverfahrens nach einem der vorangehenden Ansprüche auszuführen, wenn es von einem Computer durchgeführt wird.

$$h_{mn} = 1$$

$m$

$n$

$N$

$M$

# FIG. 1

$$\boldsymbol{\alpha} = (\alpha_1, \alpha_2, \ldots, \alpha_N) \longrightarrow$$

$$\left. \begin{array}{l} \forall n \in \{1, \ldots N\} \\ \forall m \in H(n) \end{array} \right\} \quad \alpha_{mn} = \alpha_n$$

$$Iter = 0$$

210

$$\forall m \in \{1, \ldots M\} \qquad \forall n \in H(m)$$

$$\beta_{mn} = F_C\left(\{\alpha_{mn'} | n' \in H(m) - \{n\}\}\right)$$

220

$$\forall n \in \{1, \ldots N\} \qquad \forall m \in H(n)$$

$$\alpha_{mn} = F_V\left(\{\beta_{m'n} | m' \in H(n) - \{m\}\}\right)$$

230

$$\forall n \in \{1, \ldots N\}$$

$$\hat{\alpha}_n = F_{AP}\left(\{\alpha_n\} \cup \{\beta_{mn} | m \in H(n)\}\right)$$

240

$$\forall n \in \{1, \ldots N\} \qquad \overline{\alpha}_n = F_D(\hat{\alpha}_n)$$

250

260 — Y → 265

N

$$Iter = Iter + 1$$ 267

270 $Iter = Iter\_\max$ — Y → 275

N

FIG. 2

$\beta_{mn}$

$\alpha_{mn}$

(a)

(b)

FIG. 3

FIG. 4

FIG. 5

EP 2 047 605 B1

FIG. 6A FIG. 6B

$\alpha = \left( \alpha_1, \alpha_2, ..., \alpha_N \right)$ → 710

720

725

740

750

760 —Y→ 765

N

767

770 —Y→ 775

N

# FIG. 7

$\boldsymbol{\alpha} = (\alpha_1, \alpha_2, ..., \alpha_N)$

**810**
$$\forall n \in \{1,...N\}, \forall m \in H(n) \quad \alpha_{mn} = \alpha_n$$
$$\forall m \in \{1,.., M\}, \forall n \in H(m) \quad \beta_{mn} = 0$$
$$Iter = 0$$

**820**
$$\tilde{f}_d(m_0) \geq \tilde{f}_d(m_1) \geq ... \geq \tilde{f}_d(m_{M-1})$$
$$j = 0$$

**825**
$$m = m_j$$

**830**
$$\forall n \in H(m) \quad \alpha_{mn} = F_V\left(\left\{\beta_{m'n} \,\middle|\, m' \in H(n) - \{m\}\right\}\right)$$

**835**
$$\forall n \in H(m) \quad \beta_{mn} = F_C\left(\left\{\alpha_{mn'} \,\middle|\, n' \in H(m) - \{n\}\right\}\right)$$

**837**
$$j = j + 1$$

**839**
$$j = M$$
N    Y

**840**
$$\forall n \in \{1,...N\} \quad \hat{\alpha}_n = F_{AP}\left(\{\alpha_n\} \cup \{\beta_{mn} \,|\, m \in H(n)\}\right)$$

**850**
$$\forall n \in \{1,...N\} \quad \overline{\alpha}_n = F_D(\hat{\alpha}_n)$$

**860**   Y &rarr; **865**
N

**867**
$$Iter = Iter + 1$$

**870**   N / Y &rarr; **875**

FIG. 8

$$\boldsymbol{\alpha} = (\alpha_1, \alpha_2, ..., \alpha_N) \longrightarrow \boxed{\begin{array}{l} \forall n \in \{1,...N\}, \forall m \in H(n) \quad \alpha_{mn} = \alpha_n \\ \forall m \in \{1,..,M\}, \forall n \in H(m) \quad \beta_{mn} = 0 \\ \qquad\qquad Iter = 0 \end{array}} \quad 910$$

$$\boxed{\begin{array}{l} \widetilde{f}_d(m \in G_0) \geq \widetilde{f}_d(m \in G_1) \geq ... \geq \widetilde{f}_d(m \in G_\omega) \\ \qquad\qquad\qquad j = 0 \end{array}} \quad 920$$

$$\boxed{G = G_j} \quad 925$$

$$\boxed{\forall m \in G_j, \forall n \in H(m) \qquad \alpha_{mn} = F_V\left(\left\{\beta_{m'n} \middle| m' \in H(n) - \{m\}\right\}\right)} \quad 930$$

$$\boxed{\forall m \in G_j, \forall n \in H(m) \qquad \beta_{mn} = F_C\left(\left\{\alpha_{mn'} \middle| n' \in H(m) - \{n\}\right\}\right)} \quad 935$$

$$\boxed{j = j + 1} \quad 937$$

N $\longleftarrow \diamond\ j = \omega\ \diamond \quad 939$

Y

$$\boxed{\forall n \in \{1,...N\} \qquad \hat{\alpha}_n = F_{AP}\left(\{\alpha_n\} \cup \left\{\beta_{mn} \middle| m \in H(n)\right\}\right)} \quad 940$$

$$\boxed{\forall n \in \{1,...N\} \qquad \overline{\alpha}_n = F_D(\hat{\alpha}_n)} \quad 950$$

$\diamond\ 960\ \diamond \xrightarrow{\ Y\ } \boxed{965}$

N

$967 \quad \boxed{Iter = Iter + 1}$

N $\longleftarrow \diamond\ 970\ \diamond \xrightarrow{\ Y\ } \boxed{975}$

## FIG. 9

$$\alpha = (\alpha_1, \alpha_2, ..., \alpha_N)$$

$$\forall n \in \{1, ...N\}, \forall m \in H(n) \qquad \alpha_{mn} = \alpha_n$$
$$\forall m \in \{1, .., M\}, \forall n \in H(m) \qquad \beta_{mn} = 0$$
$$Iter = 0$$

1010

$$\forall n \in \{1, ...N\} \quad \overline{\alpha}_n = \text{sgn}(\hat{\alpha}_n)$$

1015

$$\chi = \sum_{m=1}^{M} \prod_{n \in H(m)} \overline{\alpha}_n$$

1020

1023 — $\chi = M$ — Y → 1025

N

$$\forall m \in \{1, .., M\}$$
$$\widetilde{f}_2(m) = c + \sum_{n \in H(m)} \min(1, Card\{m' \in H(n) - \{m\} | c_{m'} = -1\})$$
$$j = 0$$

1027

$$G = G_j$$

1029

$$\forall m \in G_j, \forall n \in H(m) \quad \alpha_{mn} = \hat{\alpha}_n - \beta_{mn}$$

1030

$$\forall m \in G_j, \forall n \in H(m) \quad \beta_{mn} = \left( \prod_{n' \in H(m) - \{n\}} \text{sgn}(\alpha_{mn'}) \right) \cdot \min_{n' \in H(m) - \{n\}} (|\alpha_{mn'}|)$$

1035

$$\hat{\alpha}_n = \alpha_n + \sum_{m \in H(n)} \beta_{mn}$$

1040

$$j = j + 1$$

1043

1045 — $j = 2\delta_{max} + 1$

N

Y

$$Iter = Iter + 1$$

1050

N — 1053 — Y → 1055

FIG. 10

FIG. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050268204 A

**Littérature non-brevet citée dans la description**

- **R. Gallager.** Low density parity check codes. *IEEE Trans. Inform. Theory,* 1962, vol. IT-8, 21-28
- **C. Berrou et al.** Near optimum error correcting coding and decoding : turbocodes. *IEEE Trans. Inform. Theory,* 1996, vol. 44 (10), 1261-1271
- **N. Wiberg.** *Codes and decoding on général graphs,* 1996
- **J. Zhang et al.** Shuffled iterative decoding. *IEEE Trans. On Comm.,* Février 2005, vol. 53 (2), 209-213